# EUROPEAN PATENT SPECIFICATION

(11) **EP 4 280 578 B1**
(45) Date of publication and mention of the grant of the patent: **03.06.2026**
(21) Application number: 23709306.7
(22) Date of filing: 20.02.2023
(51) Int. Cl.: H04M 1/02, H04M 1/18, G06F 1/16, F16H 19/04, F16H 57/00, F16H 57/021, F16H 57/023, H02K 7/116

(54) **GEAR STRUCTURE AND ELECTRONIC DEVICE COMPRISING SAME**
GETRIEBESTRUKTUR UND ELEKTRONISCHE VORRICHTUNG DAMIT
STRUCTURE D'ENGRENAGE ET DISPOSITIF ÉLECTRONIQUE COMPRENANT CELLE-CI

(30) Priority: 22.03.2022 KR 20220035586; 25.07.2022 KR 20220092031
(43) Date of publication of application: 22.11.2023
(73) Proprietor: Samsung Electronics Co., Ltd., Suwon-si, Gyeonggi-do 16677 (KR)
(72) Inventor: YOON, Yeonggyu, Suwon-si, Gyeonggi-do 16677 (KR); KANG, Youngmin, Suwon-si, Gyeonggi-do 16677 (KR); SHIN, Moonchul, Suwon-si, Gyeonggi-do 16677 (KR); CHO, Joongyeon, Suwon-si, Gyeonggi-do 16677 (KR); CHOI, Junyoung, Suwon-si, Gyeonggi-do 16677 (KR); YOON, Byounguk, Suwon-si, Gyeonggi-do 16677 (KR); LEE, Junghyeob, Suwon-si, Gyeonggi-do 16677 (KR); CHO, Sunggun, Suwon-si, Gyeonggi-do 16677 (KR)
(74) Representative: Gulde & Partner
(86) International application number: PCT/KR2023/002417
(87) International publication number: WO 2023/182671

(56) References cited:
- WO-A1-2022/004908
- KR-A- 20220 035 089
- KR-B1- 101 179 115
- KR-B1- 101 581 220
- US-A1- 2021 044 683

## Description

### [Technical Field]

Various embodiments of the disclosure relate to an electronic device, e.g., a gear structure and an electronic device including the same.

### [Background Art]

Advancing information communication and semiconductor technologies accelerate the spread and use of various electronic devices. In particular, recent electronic devices are being developed to carry out communication while carried on.

The term "electronic device" may mean a device performing a particular function according to its equipped program, such as a home appliance, an electronic scheduler, a portable multimedia player, a mobile communication terminal, a tablet PC, a video/sound device, a desktop PC or laptop computer, a navigation for automobile, etc. For example, electronic devices may output stored information as voices or images. As electronic devices are highly integrated, and high-speed, high-volume wireless communication becomes commonplace, an electronic device, such as a mobile communication terminal, is recently being equipped with various functions. For example, an electronic device comes with the integrated functionality, including an entertainment function, such as playing video games, a multimedia function, such as replaying music/videos, a communication and security function for mobile banking, or a scheduling or e-wallet function. Such electronic devices become compact enough for users to carry in a convenient way.

As mobile communication services extend up to multimedia service sectors, the display of the electronic device may be increased to allow the user satisfactory use of multimedia services as well as voice call or text messaging services.

KR 101 179 115 B1 discloses a conventional electronic device including a gear structure. WO 2022/004908 A1 discloses a conventional slidable electronic device including a display including a first display area and a second display area extending from the first display area and configured so that at least a portion of the second display area is configured to be moved based on a sliding movement of a first housing. KR 101 581 220 B1 discloses a conventional disengaging gear structure.

### [Disclosure]

### [Technical Problem]

An electronic device (e.g., a portable terminal) includes a display with a flat surface or both a flat and curved surface. An electronic device including a display may have a limitation in realizing a screen larger than the size of the electronic device due to the fixed display structure. Accordingly, research has been conducted on electronic devices including a rollable display.

In an electronic device including a rollable display, a partial area of the display and/or the electronic device may be extended or shrunken when slid. An electronic device including a rollable display may include a motor and a gear structure connected thereto to increase the size of a partial area of the electronic device.

As an example, the motor may be disposed on at least a portion of the electronic device, and the gear structure may be disposed on a portion different from the at least one portion of the electronic device. For example, as the motor is rotated in one direction or its opposite direction, the gear structure connected with the motor may be slid in a first direction or a second direction opposite to the first direction.

When the electronic device including a rollable display is dropped, an external impact may be applied to the housing constituting the exterior of the electronic device. At this time, the motor and the gear structure disposed in the electronic device may be broken or damaged by the external impact momentarily applied while meshing with each other.

According to various embodiments of the disclosure, there may be provided a gear structure that may release dynamic connection between at least a portion thereof and the motor when external impact is applied to the electronic device and an electronic device including the same.

The disclosure is not limited to the foregoing embodiments but various modifications or changes may rather be made thereto without departing from the scope of the disclosure.

### [Technical Solution]

The invention is defined by the independent claim. The dependent claims define further advantageous embodiments. The description that follows is subjected to this limitation. Any disclosure lying outside the scope of said claims is only intended for illustrative as well as comparative purposes.

### [Advantageous Effects]

According to various embodiments of the disclosure, it is possible to release dynamic connection between at least a portion thereof and the motor when external impact is applied to the electronic device.

According to various embodiments of the disclosure, when external impact is applied to the electronic device, the gear structure or motor structure may be prevented from damage or breakage.

Effects of the disclosure are not limited to the foregoing, and other unmentioned effects would be apparent to one of ordinary skill in the art from the following description.

### [Description of the Drawings]

FIG. 1 is a view illustrating an electronic device in a network environment according to various embodiments;
FIG. 2A is a view illustrating a closed state of an electronic device according to various embodiments of the disclosure;
FIG. 2B is a view illustrating an opened state of an electronic device according to various embodiments of the disclosure;
FIG. 2C is a view illustrating an opened state of an electronic device according to various embodiments of the disclosure, as a state of the electronic device of FIG. 2B when viewed from a direction opposite to that of FIG. 2B;
FIG. 3 is a perspective view illustrating an electronic device according to various embodiments of the disclosure;
FIG. 4A is a cross-sectional view illustrating a closed state of an electronic device according to various embodiments of the disclosure;
FIG. 4B is a cross-sectional view illustrating an opened state of an electronic device according to various embodiments of the disclosure;
FIG. 5 is an exploded perspective view illustrating an electronic device and a motor structure according to various embodiments of the disclosure;
FIG. 6 is a perspective view illustrating a coupling relationship between an electronic device and a motor structure according to various embodiments of the disclosure;
FIG. 7A is a perspective view illustrating a coupled state of a gear structure according to various embodiments of the disclosure;
FIG. 7B is a perspective view illustrating a second gear portion according to various embodiments of the disclosure;
FIG. 7C is a perspective view illustrating the second gear portion as viewed in a direction different from that of FIG. 7B, according to various embodiments of the disclosure;
FIG. 7D is a perspective view illustrating a third gear portion according to various embodiments of the disclosure;
FIG. 7E is a perspective view illustrating the third gear portion as viewed in a direction different from that of FIG. 7D, according to various embodiments of the disclosure;
FIG. 7F is a perspective view illustrating a coupling relationship between a second gear portion and a third gear portion according to various embodiments of the disclosure;
FIG. 7G is a perspective view illustrating a driving member according to various embodiments of the disclosure;
FIG. 7H is a perspective view illustrating a coupling relationship between a driving member and a gear structure according to various embodiments of the disclosure;
FIG. 8A is a perspective view illustrating a coupling relationship between a gear structure and a gear frame according to various embodiments of the disclosure;
FIG. 8B is a perspective view illustrating a coupling relationship between the gear structure and the gear frame as viewed in a direction different from that of FIG. 8A, according to various embodiments of the disclosure;
FIG. 9A is a view illustrating a closed state of an electronic device according to various embodiments of the disclosure;
FIG. 9B is a view illustrating an opened state of an electronic device according to various embodiments of the disclosure;
FIG. 9C is an enlarged view illustrating portion A of FIG. 9B according to various embodiments of the disclosure;
FIG. 10A is a perspective view illustrating a state in which a motor and a gear structure are dynamically connected to each other according to various embodiments of the disclosure;
FIG. 10B is a cross-sectional view illustrating a state in which a motor and a gear structure are dynamically connected to each other according to various embodiments of the disclosure;
FIG. 11A is a perspective view illustrating a state in which a motor and a gear structure are dynamically disconnected from each other according to various embodiments of the disclosure; and
FIG. 11B is a cross-sectional view illustrating a state in which a motor and a gear structure are dynamically disconnected from each other according to various embodiments of the disclosure.

### [Mode for Invention]

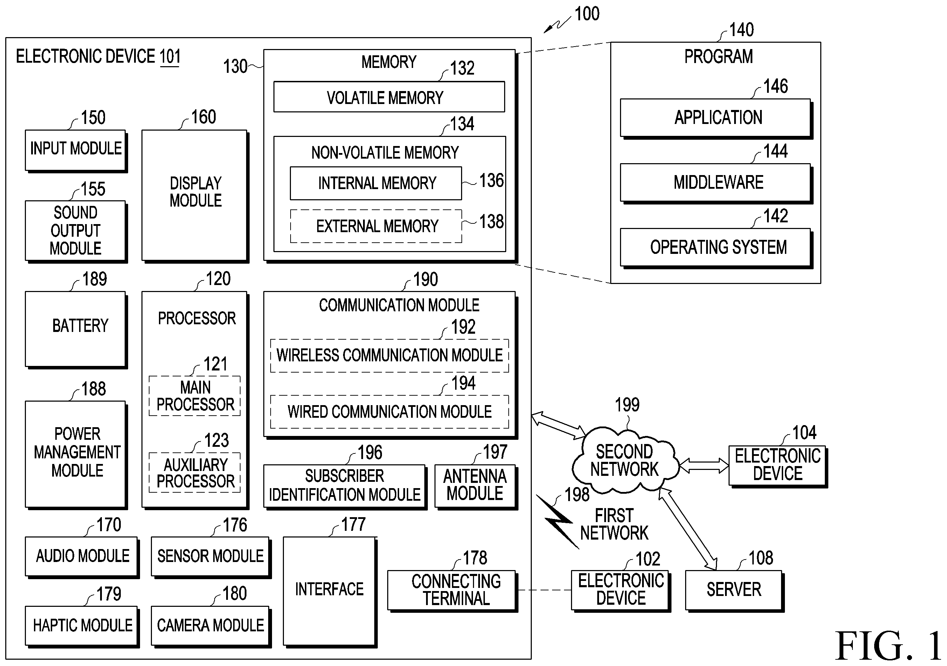

FIG. 1 is a block diagram illustrating an electronic device 101 in a network environment 100 according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

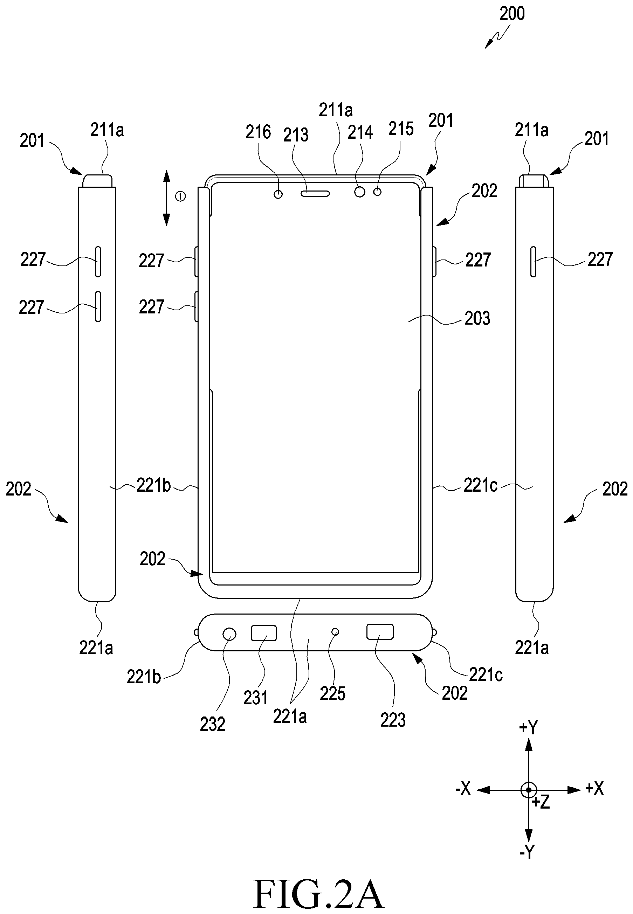

FIGS. 2A to 11B illustrate a spatial coordinate system for convenience of description. As illustrated in FIGS. 2A to 11B, the X-axis direction may be defined and interpreted as the width direction of the electronic device and components of the electronic device, the Y-axis direction may be defined and interpreted as the length direction or sliding direction of the electronic device and components of the electronic device, and the Z-axis direction may be defined and interpreted as the thickness direction of the electronic device and components of the electronic device.

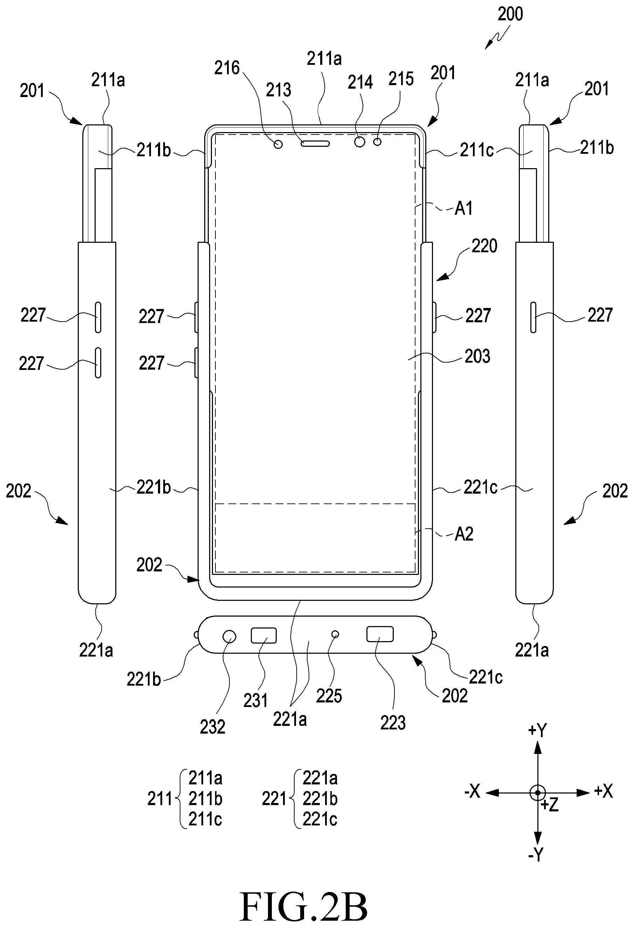

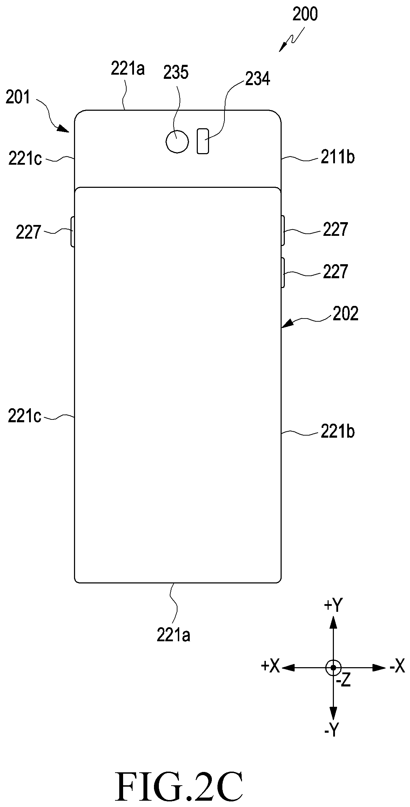

FIG. 2A is a view illustrating a closed state of an electronic device according to various embodiments of the disclosure. FIG. 2B is a view illustrating an opened state of an electronic device according to various embodiments of the disclosure. FIG. 2C is a view illustrating an opened state of an electronic device according to various embodiments of the disclosure, as a state of the electronic device of FIG. 2B when viewed from a direction opposite to that of FIG. 2B.

The state of the electronic device 200 illustrated in FIG. 2A may be referred to as a slide-in state or a first state of the electronic device 200 or the housings 201 and 202. For example, the first state may be defined as a state in which the first housing 201 is closed with respect to the second housing 202 (closed state) or a state in which the second display area A2 is received in the housings 201 and 202. The state of the electronic device 200 illustrated in FIG. 2B or 2C may be referred to as a slide-out state or a second state. For example, the second state may be defined as a state in which the first housing 201 is opened with respect to the second housing 202 (opened state) or a state in which the second display area A2 is exposed to the outside of the housings 201 and 202. According to an embodiment, the "closed state" may be defined and/or interpreted as a state in which the electronic device is closed, and the "opened state" may be defined and/or interpreted as a state in which the electronic device is opened.

FIGS. 2A and/or 2B illustrate a structure in which the display 203 (e.g., flexible display or rollable display) is extended in the upper direction (e.g., +Y direction of FIGS. 2A to 2C) when the electronic device 200 is viewed from the front. However, the extending direction of the display 203 is not limited to one direction (e.g., the upper direction), but the electronic device 200 may be changed in design so that the display 203 is extendable in the right direction (e.g., the +X direction of FIGS. 2A to 2C), the left direction (e.g., the -X direction of FIGS. 2A to 2C) or the lower direction (e.g., the -Y direction of FIGS. 2A to 2C).

Referring to FIGS. 2A to 2C, an electronic device 200 (e.g., the electronic device 101 of FIG. 1) may include housings 201 and 202 and/or a display 203. According to various embodiments, the housings 201 and 202 may include a second housing 202 and a first housing 201 that is disposed to be movable with respect to the second housing 202. According to an embodiment, the electronic device 200 may be interpreted as having a structure in which the second housing 202 is slidably disposed on the first housing 201. According to an embodiment, the first housing 201 may be disposed to perform reciprocating motion by a predetermined distance in a predetermined direction with respect to the second housing 202, for example, a direction indicated by an arrow ①. The configuration of the electronic device 200 of FIGS. 2A to 2C may be identical in whole or part to the configuration of the electronic device 101 of FIG. 1.

According to an embodiment, the first housing 201 may be referred to as, e.g., a first structure, a slide part, or a slide housing, and may be disposed to reciprocate on the second housing 202. In an embodiment, the first housing 201 may be movable relative to the second housing 202. According to an embodiment, the second housing 202 may be referred to as, e.g., a second structure, a main part, or a main housing. According to an embodiment, the second housing 202 may receive at least a portion of the first housing 201 and may guide the sliding movement of the first housing 201. According to an embodiment, at least a portion (e.g., the first display area A1 or the second display area A2) of the display 203 may be visually exposed to the outside of the housings 201 and 202. According to an embodiment, the housings 201 and 202 may receive various electrical/electronic components, such as a main circuit board or a battery. In an embodiment, in the housings 201 and 202, a motor, a battery, a speaker, a sim socket, a sub circuit board electrically connected with a main circuit board, and/or the main circuit board having an application processor (AP), a communication processor (CP), or other electric components mounted thereon may be disposed.

According to an embodiment, the first housing 201 may include a first plate 211 (e.g., a front cover). According to an embodiment, the first plate 201 may support at least a portion (e.g., the first display area A1) of the display 203. According to an embodiment, the first plate 211 may include first sidewalls 211a, 211b, and 211c to surround at least a portion of the display 203. According to an embodiment, the first sidewalls 211a, 211b, and 211c may include a 1-1th sidewall 211a, a 1-2th sidewall 211b extending from the 1-1th sidewall 211a, and a 1-3th sidewall 211c extending from the 1-1th sidewall 211a. The 1-3th sidewall 211c may be disposed substantially parallel to the 1-2th sidewall 211b. According to an embodiment, the 1-2th sidewall 211b and the 1-3th sidewall 211c may be formed or disposed substantially perpendicular to the 1-1th sidewall 211a.

According to an embodiment, in the closed state (e.g., FIG. 2) of the electronic device 200, the 1-2th sidewall 211b may face the 2-2th sidewall 221b of the second housing 202, and the 1-3th sidewall 211c may face the 2-3th sidewall 221c of the second housing 202. According to an embodiment, the first plate 211, the 1-1th sidewall 211a, the 1-2th sidewall 211b, and/or the 1-3th sidewall 211c may be integrally formed. According to another embodiment, the first plate 211, the 1-1th sidewall 211a, the 1-2th sidewall 211b, and/or the 1-3th sidewall 211c may be formed as separate housings and be combined or assembled.

According to various embodiments, the second housing 202 may be referred to as, e.g., a second structure, a main part, or a main housing. The second housing 202 may include a second plate 221 (e.g., a book cover).

According to various embodiments, the second plate 221 may include second sidewalls 221a, 221b, and 221c for surrounding at least a portion of the first housing 201 (or at least a portion of the first plate 211). According to an embodiment, the second sidewalls 221a, 221b, and 221c may include a 2-1th sidewall 221a, a 2-2th sidewall 221b extending from the 2-1th sidewall 221a, and a 2-3th sidewall 221c extending from the 2-1th sidewall 221a. The 2-3th sidewall 221c may be disposed substantially parallel to the 2-2th sidewall 221b. According to an embodiment, the 2-1th sidewall 221a may be substantially perpendicular to the 2-2th sidewall 221b and/or the 2-3th sidewall 221c. According to an embodiment, the 2-2th sidewall 221b may face the 1-2th sidewall 211b, and the 2-3th sidewall 221c may face the 1-3th sidewall 211c. For example, in the closed state (e.g., FIG. 2A) of the electronic device 101, the 2-2th sidewall 221b may cover at least a portion of the 1-2th sidewall 211b, and the 2-3th sidewall 221c may cover at least a portion of the 1-3th sidewall 211c. According to an embodiment, the second plate 221, the 2-1th sidewall 221a, the 2-2th sidewall 221b, and/or the 2-3th sidewall 221c may be integrally formed. According to another embodiment, the second plate 221, the 2-1th sidewall 221a, the 2-2th sidewall 221b, and/or the 2-3th sidewall 221c may be formed as separate housings and be combined or assembled.

According to various embodiments, the second plate 221 may be formed to have an open side (e.g., open front surface) to receive (or surround) at least a portion of the first plate 211. For example, the first housing 211 may be connected to the second plate 211 while being at least partially surrounded by the 2-1th sidewall 221a, the 2-2th sidewall 221b, and the 2-3th sidewall 221c and may be slid in the direction of arrow ① while being guided by the second housing 221. For example, the first housing 201 may be at least partially surrounded with respect to the second housing 202 and slide in the direction of arrow ① while being guided by the second housing 220.

According to various embodiments, the second plate 221 may be configured to cover at least a portion of the display 203. For example, at least a portion of the display 203 (e.g., the second display area A2) may be received in the second housing 202, and the second plate 221 and/or the 2-1th sidewall 221a may cover at least a portion (e.g., the second display area A2) of the display 203 received in the second housing 202.

According to various embodiments, the electronic device 200 may include a display 203. For example, the display 203 may be interpreted as a flexible display or a rollable display. According to an embodiment, at least a portion of the display 203 (e.g., the second display area A2) may slide based on the sliding movement of the first housing 201.

According to an embodiment, the display 203 may include a first display area A1 and a second display area A2 configured to be exposed to the outside of the electronic device 200 based on the sliding movement of the first housing 201 (or first plate 211).

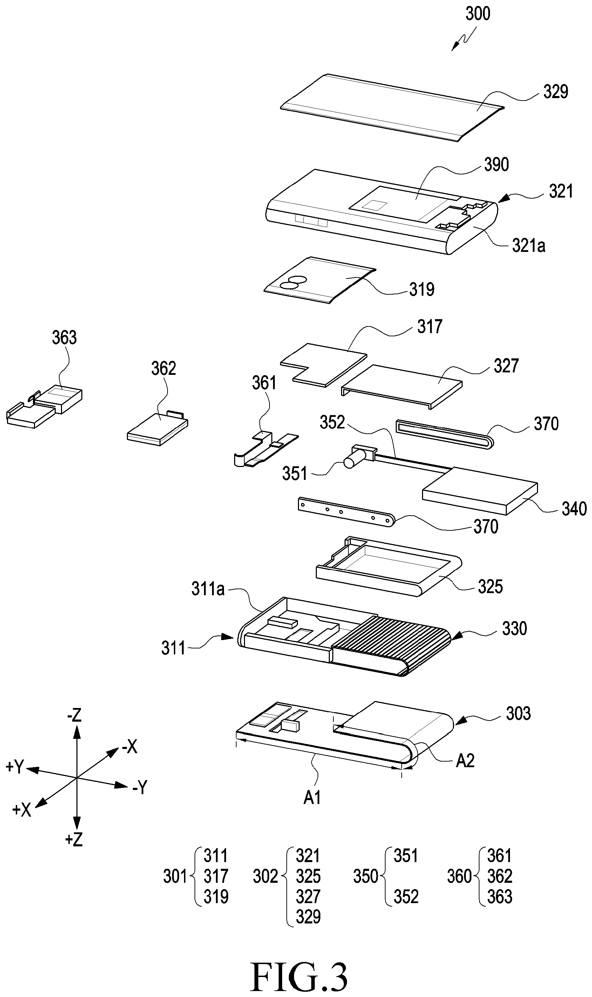

According to an embodiment, the display 203 may include, or be disposed adjacent to, a touch detection circuit, a pressure sensor capable of measuring the intensity (pressure) of a touch, and/or a digitizer that detects a magnetic field-type stylus pen. The configuration of the display 203 of FIGS. 2 and 3 may be identical in whole or part to the configuration of the display module 160 of FIG. 1.

According to various embodiments, the display 203 may include a first display area A1 and a second display area A2. According to an embodiment, the first display area A1 may be an area that is always visible from the outside of the electronic device 200. According to an embodiment, the first display area A1 may be interpreted as an area that cannot be positioned inside the housing 201, 202 and/or the second housing 202. According to an embodiment, the second display area A2 may extend from the first display area A1, and the second display area A2 may be inserted or received in, or visually exposed to the outside of, the second housing 202 as the first housing 201 slides.

According to various embodiments, the second display area A2 may be substantially moved while being guided by the supporting structure (e.g., the supporting structure 330 of FIG. 3) mounted in the second housing 202 and may be thus received in the second housing 202 or a space formed between the first housing 201 and the second housing 202 or be visually exposed to the outside of the electronic device 200. According to an embodiment, the second display area A2 may be moved based on the sliding movement of the first housing 201 in the length direction (e.g., the direction indicated by the arrow ①). For example, at least a portion of the second display area A2 may be moved while being guided by the supporting structure (e.g., the supporting structure 330 of FIG. 3) based on the sliding movement of the first housing 201. For example, at least a portion of the second display area A2 may be unfolded or rolled along with at least a portion of the supporting structure (e.g., the supporting structure 330 of FIG. 3).

According to various embodiments, when viewed from above the first housing 201, if the first housing 201 moves from the closed state to the opened state (e.g., from FIG. 2A to FIG. 2B), the second display area A2 may be gradually exposed to the outside of the housings 201 and 202 to be substantially coplanar with the first display area A1. In an embodiment, the second display area A2 may be at least partially received in the first housing 201 and/or the second housing 202. According to an embodiment, when viewed from above the first housing 201, if the first housing 201 moves from the opened state to the closed state (e.g., from FIG. 2B to FIG. 2A), the second display area A2 may be gradually received in the housings 201 and 202 while at least a portion of the second display area A2 may be rolled.

According to an embodiment, the first housing 201 may be moved in the opened state (refer to, e.g., FIG. 2B or 2C) and closed state (refer to, e.g., FIG. 2A) with respect to the second housing 202 in the first direction (e.g., direction of arrow ①) parallel to the second plate 221 and the second sidewall 221b. In the closed state, the first housing 201 may be placed at a first distance from the 2-1th sidewall 221a. In the opened state, the first housing 201 may move to be placed at a second distance larger than the first distance from the 2-1th sidewall 221a.

According to an embodiment, when viewed from above the first plate 211, if the first housing 201 moves from the closed state to the opened state, at least a portion of the bendable portion (e.g., the second display area A2) of the display 203 may be configured to form a substantially flat surface. According to an embodiment, the display 203 may include a flexible touchscreen display layer.

According to an embodiment, the audio modules 213, 223, and 225 may include speaker holes 213 and 223 and a microphone hole 225. The speaker holes 213 and 223 may include a receiver hole 213 or an external speaker hole 223. The microphone hole 225 may have a microphone inside to obtain external sounds. According to an embodiment, there may be a plurality of microphones to be able to detect the direction of a sound. According to an embodiment, the speaker holes 213 and 223 and the microphone hole 225 may be implemented as a single hole, or speakers may be included without the speaker holes 213 and 223 (e.g., piezo speakers). According to an embodiment, the receiver hole 213 may be disposed in the first housing 201. The external speaker hole 223 or the microphone hole 225 may be disposed in the second housing 202. According to another embodiment, the external speaker hole 223 may be disposed in the rear surface (e.g., the surface shown in FIG. 2C) of the first plate 211 or in a side surface of the first housing 201. According to an embodiment, the microphone hole 225 may be disposed on a side surface of the second housing 202.

According to an embodiment, the sensor modules 214 may generate an electrical signal or data value corresponding to an internal operating state or external environmental state of the electronic device 200. The sensor modules 214 may include a first sensor module 214 (e.g., a proximity sensor) disposed on, e.g., the front surface (e.g., the surface shown in FIG. 2A or 2B) of the first plate 211 and/or a second sensor module (e.g., a fingerprint sensor) (not shown) disposed on the rear surface (e.g., the surface shown in FIG. 2C) of the first plate 211 and/or a third sensor module 234 (e.g., an HRM sensor). The electronic device 200 may include a sensor module not shown, e.g., at least one of a gesture sensor, a gyro sensor, a barometric sensor, a magnetic sensor, an acceleration sensor, a grip sensor, a color sensor, an infrared (IR) sensor, a biometric sensor, a temperature sensor, a humidity sensor, or an illuminance sensor.

According to an embodiment, the camera modules 215 and 235 may include a first camera module 215 disposed on the front surface (e.g., the surface shown in FIG. 2A or 2B) of the first plate 211 and a second camera module 235 disposed on the rear surface (e.g., the surface shown in FIG. 2C) of the first plate 211. The first camera module 215 or the second camera module 235 may include one or more lenses, an image sensor, and/or an image signal processor. According to an embodiment, the first camera module 215 disposed on the display 203 may be configured as an under display camera (UDC). According to an embodiment, the second camera module 235 may be disposed on one surface of the second housing 202 (or the second plate 221).

According to an embodiment, the key input device 227 may be disposed on the second sidewall 221b or the third sidewall 221c of the second housing 202. The electronic device 200 may include a key input device (not shown), e.g., a home key button or a touchpad disposed around the home key button. According to an embodiment, at least a portion of the key input device 227 may be positioned in an area of the first housing 201 and/or the second housing 202.

According to an embodiment, the indicator 216 may be disposed on the front surface (e.g., the surface shown in FIG. 2A or FIG. 2C) of the first plate 211. The indicator 216 may provide, e.g., state information about the electronic device 200 in the form of light and may include an LED.

According to an embodiment, the connector holes 231 and 232 may include, e.g., a first connector hole 231 for receiving a connector (e.g., a universal serial bus (USB) connector) for transmitting or receiving power and/or data to/from an external electronic device and/or a second connector hole (e.g., an earphone jack) 232 for receiving a connector for transmitting or receiving audio signals to/from the external electronic device. According to an embodiment, the first connector hole 231 or the second connector hole 232 may be disposed or formed on the first sidewall 221a of the second housing 202 or the second plate 221. According to an embodiment, the first connector hole 231 or the second connector hole 232 may be omitted.

FIG. 3 is a perspective view illustrating an electronic device according to various embodiments of the disclosure.

Referring to FIG. 3, an electronic device 300 (e.g., the electronic device 101 of FIG. 1 or the electronic device 200 of FIG. 2A) may include a first housing 301, a second housing 302, a display 303, a battery 340, a printed circuit board 360, a guide rail 370, and/or a motor structure 350.

The configuration of the first housing 301, the second housing 302, and/or the display 303 of FIG. 3 may be identical in whole or part to the configuration of the first housing 201, the second housing 202, and/or the display 203 of FIGS. 2A to 2C.

According to various embodiments, the first housing 301 (e.g., the first housing 201 of FIGS. 2A to 2C) may include a first plate 311 (e.g., the first plate 311 of FIGS. 2A to 2C), a rear cover 317 and/or a first back cover 319.

According to various embodiments, the second housing 302 (e.g., the second housing 202 of FIGS. 2A to 2C) may include a second plate 321 (e.g., the second plate 321 of FIGS. 2A to 2C), a guide frame 325, a battery plate 327, and/or a second back cover 329.

In an embodiment, the components 311, 317, and 319 of the first housing 301 may be interpreted as components that move relative to the second housing 302 according to the sliding movement (e.g., opening operation or closing operation) of the electronic device 300. In an embodiment, the components 321, 325, 327, and 329 of the second housing 302 may be interpreted as components that have a fixed position or arrangement with respect to the components 311, 317, and 319 of the first housing 301 which relatively move according to the sliding movement (e.g., opening operation or closing operation) of the electronic device 300.

According to an embodiment, at least a portion of the display 303 (e.g., the display 203 of FIGS. 2A to 2C) may be disposed inside the first housing 301 and/or second housing 302 or in an internal space formed as they are coupled together. According to an embodiment, the display 303 may include a first display area A1 (e.g., the first display area A1 of FIG. 2B) disposed on the first housing 301 or the first plate 311 and a second display area A2 (e.g., the second display area A2 of FIG. 2B) extending from the first display area A1.

According to an embodiment, the second display area A2 may be an area in which at least a portion of the display 303 is bent. According to an embodiment, the first display area A1 may be disposed on one surface (e.g., the surface facing in the +Z direction of FIG. 3) of the first plate 311 and be visually exposed to the outside of the electronic device 300. The second display area A2 may be disposed between the first plate 311 and the second plate 321 not to be visually exposed to the outside of the electronic device 300 in the closed state (e.g., FIG. 2A) of the electronic device 300. The second display area A2 may be visually exposed to the outside of the electronic device 300 in the opened state (e.g., FIG. 2B) of the electronic device 300.

For example, when the first plate 311 and/or the first housing 301 slides in the slide-out direction (e.g., +Y direction of FIG. 3) with respect to the second plate 321 and/or the second housing 302, the second display area A2, along with the first display area A1, may slide in the sliding direction (e.g., +Y direction of FIG. 3), and the second display area A2 may be visually exposed to the outside of the electronic device 300. In this case, the second display area A2 may be substantially coplanar with the first display area A1 while the rolled portion is unrolled.

For example, when the first plate 311 and/or the first housing 301 slides in the slide-in direction (e.g., -Y direction of FIG. 3) with respect to the second plate 321 and/or the second housing 302, the second display area A2, along with the first display area A1, may slide in the sliding direction (e.g., -Y direction of FIG. 3), and at least a portion of the second display area A2 may be received in a rolled shape between the first plate 311 and the second plate 321.

According to an embodiment, the first plate 311 may be formed of a metal material and/or a non-metal (e.g., polymer) material. The first plate 311 may have one surface (e.g., the surface facing in the +Z direction of FIG. 3) where at least a portion of the display 303 may be disposed and the other surface (e.g., the surface facing in the -Z direction of FIG. 3) where the printed circuit board 360 may be disposed.

According to an embodiment, the second plate 321 may be formed of a metal material and/or a non-metal (e.g., polymer) material. According to an embodiment, the second plate 321 may be formed to surround or cover at least a portion of the first plate 311 or the display 303. According to an embodiment, the second back cover 329 may be configured to cover at least a portion of one surface (e.g., the face facing in the -Z direction of FIG. 3) of the second plate 321.

According to an embodiment, an electric component 390 (e.g., a near-field communication (NFC) antenna, a magnetic secure transmission (MST) antenna, a wireless charging module (WCM), or a printed circuit board) may be disposed and/or mounted on the surface (e.g., the surface facing in the -Z direction of FIG. 3) of the second plate 321, and the second back cover 329 may be configured to cover the electric component. According to an embodiment, at least some of the electric components (e.g., a near field communication (NFC) antenna, a magnetic secure transmission (MST) antenna, and a wireless charging module (WCM)) may be disposed on the rear cover 317.

According to an embodiment, at least one of the first back cover 319 and the second back cover 329 may be formed of a material that does not transmit light. According to another embodiment, at least one of the first back cover 319 and the second back cover 329 may be formed of a material that transmits light.

According to an embodiment, the guide frame 325 may be disposed in the second plate 321. According to an embodiment, the guide frame 325 may receive the battery 340. According to an embodiment, the battery 340 may be electrically connected with the printed circuit board 360 or various electric components to feed power to the printed circuit board 360 or the electric components.

According to an embodiment, the battery 340 may be disposed in the groove formed in the guide frame 325. According to an embodiment, the battery plate 327 may be disposed on one surface (e.g., the face facing in the -Z direction of FIG. 3) of the battery 340 to protect the battery 340.

According to an embodiment, the rear cover 317 may be disposed on one side of the battery plate 327. According to an embodiment, the rear cover 317 may slide by following the sliding movement of the first plate 311. According to an embodiment, the rear cover 317 may be fixed to the first plate 311.

According to an embodiment, the first back cover 319 may be fixed to the rear cover 317 or the first plate 311. The first back cover 319 may be slide by following the sliding movement of the first plate 311. According to an embodiment, the first back cover 319 may protect the printed circuit board 360 disposed on the rear cover 317 or the first plate 311.

According to an embodiment, the guide rail 370 may guide the movement of the display 303. The guide rail 370 may be coupled or fixed to the guide frame 325 and/or the second plate 311.

According to an embodiment, the supporting structure 330 (or multi-bar structure 330) may support the display 303. According to an embodiment, the supporting structure 330 may support at least a portion of the first display area A1 or at least a portion of the second display area A2. For example, the supporting structure 330 may be connected with the display 303. For example, the supporting structure 330 may be adhered to the display 303 through an adhesive and/or an adhesive tape. In an embodiment, the supporting structure 330 may be configured to support at least a portion of the second display area A2. According to an embodiment, at least a portion of the display 303 and the supporting structure 330 may be positioned between the first plate 311 and the second plate 321. According to an embodiment, as the first housing 301 slides, the supporting structure 303 may move with respect to the second housing 302. In the closed state (e.g., FIG. 2A), most of the supporting structure 330 may be received in the second housing 302 or the second plate 321.

According to various embodiments, the supporting structure 330 may include a plurality of bars 310. The plurality of bars may extend in a straight line. According to various embodiments, each bar may slide along a groove formed in the guide rail 370 while remaining parallel to another adjacent bar. According to an embodiment, as the first housing 311 slides, the plurality of bars may be arranged to form a curved shape or a flat shape. For example, as the first plate 311 slides, a portion of the supporting structure 330 facing the 2-1th sidewall 321a (e.g., the 2-1th sidewall 221a in FIGS. 2A to 2C) may form a curved surface, and another portion of the supporting structure 330 that does not face it may form a flat surface.

According to an embodiment, the second display area A2 of the display 303 may be mounted or supported on the supporting structure 330, and in the opened state (e.g., FIG. 2B), at least a portion of the second display area A2, along with the first display area A1, may be exposed to the outside of the second housing 302 or the outside of the second plate 321. In the state in which the second display area A2 is exposed to the outside of the second housing 302, the supporting structure 330 may substantially form a flat surface, thereby supporting or maintaining the second display area A2 in the flat state. According to an embodiment, the supporting structure 330 may be replaced with a bendable integral supporting member (not shown). According to an embodiment, the supporting structure 330 may be interpreted as a display supporting multi-bar, a multi-bar structure, or an articulated hinge structure.

According to various embodiments, the guide rail 370 may guide the movement of the plurality of bars. According to an embodiment, the guide rail 370 may include a groove-shaped rail formed inside the guide rail 370 and a protrusion positioned inside the guide rail. At least a portion of the protrusion may be surrounded by the rail. According to an embodiment, the supporting structure 330 may move while remaining fitted to the groove-shaped rail. For example, the plurality of bars may slide along the rail while being fitted in the groove-shaped rail.

According to an embodiment, when the electronic device 300 is opened (e.g., a slide-out operation), the size of the area where the display 303 is exposed to the outside may be increased. For example, by the driving of the motor 351 of the motor structure 350 (e.g., driving for sliding out the display) and/or the external force provided by the user, the first plate 311 connected with the motor 351 may be slid out, and the plurality of bars of the supporting structure 330 may be slid out along the rail of the guide rail 370. For example, the rolled portion of the supporting structure 330 may flatten. Accordingly, the second display area A2 which is received between the first plate 311 and the second plate 321 may be exposed to the front surface of the second display area A2.

According to an embodiment, to transfer the power to allow the first plate 311 to slide relative to the guide frame 325 and/or the second plate 321, the motor 351 may be structurally connected to the first plate 311, and the rack gear of the gear structure 352 may be structurally connected to the guide frame 325 and/or the second plate 321.

According to an embodiment, when the electronic device 300 is closed (e.g., a slide-in operation), the size of the area where the display 303 is exposed to the outside may be reduced. For example, by the driving of the motor 351 (e.g., driving for sliding in the display) and/or the external force provided by the user, the first plate 311 where the motor 351 is disposed may be slid in, and the plurality of bars of the supporting structure 330 may be slid in along the rail of the guide rail 370. For example, the unrolled portion of the supporting structure 330 may be rolled. Accordingly, the extended second display area A2 may be rolled in between the first plate 311 and the second plate 321 and be received in the second plate 321 or the internal space formed by the first plate 311 and the second plate 321.

According to an embodiment, the motor structure 350 may include a motor 351 and a gear structure 352. According to an embodiment, the gear structure 352 may include a pinion gear connected to the motor 351 and a rack gear connected to the pinion gear. According to an embodiment, the motor 351 may be coupled to the first plate 311, and the rack gear of the gear structure 352 may be coupled to the guide frame 325. According to another embodiment, the rack gear of the gear structure 352 may be coupled to the second plate 321. According to an embodiment, the motor 351 may be coupled to the guide frame 325 or the second plate 321, and the rack gear of the gear structure 352 may be coupled to the first plate 311. According to an embodiment, the motor 351 may be defined and interpreted as being fixed to, coupled to, or disposed on the first plate 311, the guide frame 325, or the second plate 321, and the rack gear of the gear structure 352 may be defined and interpreted as being fixed to, coupled to, or disposed on the guide frame 325, the second plate 321 or the first plate 311. Further, according to an embodiment, the motor 351 and the rack gear of the gear structure 352 may have various arrangement relationships or coupling relationships capable of providing a driving force to allow the first housing 301 to slide relative to the second housing 302.

According to an embodiment, as the pinion gear connected to the motor 351 is rotated in one direction on the rack gear, the first plate 311 may slide in the first sliding direction (e.g., +Y direction of FIG. 3) with respect to the second plate 321. According to an embodiment, as the pinion gear connected to the motor 351 rotates in the other direction opposite to the one direction on the rack gear 352, the first plate 311 may slide in the sliding direction (e.g., the -Y direction of FIG. 3) with respect to the second plate 321.

According to an embodiment, the printed circuit board 360 may include a first printed circuit board 361, a second printed circuit board 362, and a third printed circuit board 363. According to an embodiment, the printed circuit board 360 may be disposed on the first plate 311 or the second plate 321.

According to an embodiment, the first printed circuit board 361 may be a power printed circuit board (PCB). The first printed circuit board 361 may be electrically connected to the battery 340 and receive power from the battery 340, and supply power to other electric components directly or indirectly electrically connected to the first printed circuit board 361. Further, the first printed circuit board 361 may transfer various signals (e.g., commands or data) between various electric components.

According to an embodiment, a processor (e.g., the processor 120 of FIG. 1), a memory (e.g., the memory 130 of FIG. 1), and/or an interface (e.g., the interface 177 of FIG. 1) may be mounted on the second printed circuit board 362. The processor may include one or more of, e.g., a central processing unit, an application processor, a graphic processing device, an image signal processing, a sensor hub processor, or a communication processor.

According to an embodiment, the third printed circuit board 363 may be disposed inside the first plate 311. The third printed circuit board 363 may move by following the movement of the first plate 311. The third printed circuit board 363 may include various electric components. According to an embodiment, the third printed circuit board 363 may be electrically connected to a camera module (e.g., the camera modules 215 and 235 of FIGS. 2A to 2C).

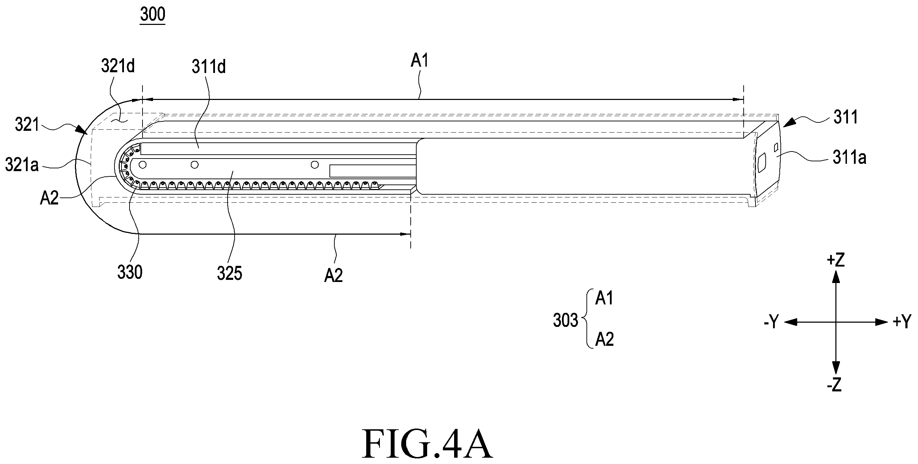

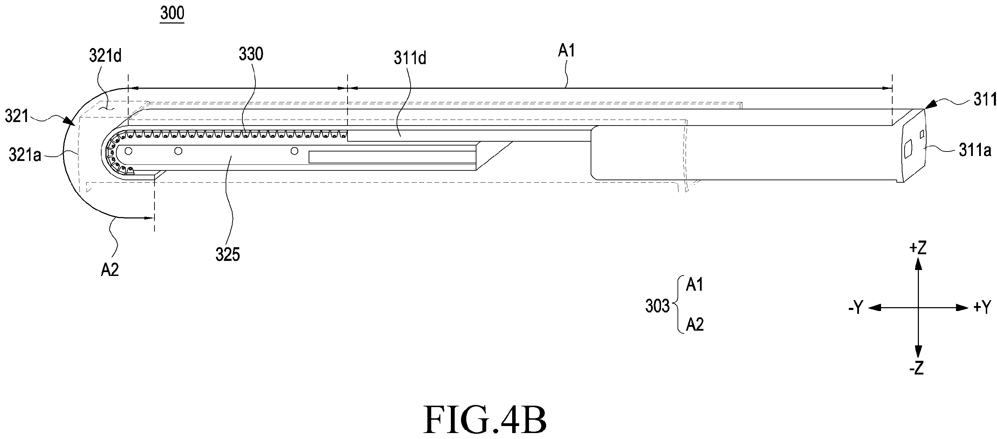

FIG. 4A is a cross-sectional view illustrating a closed state of an electronic device according to various embodiments of the disclosure. FIG. 4B is a cross-sectional view illustrating an opened state of an electronic device according to various embodiments of the disclosure.

Referring to FIGS. 4A and 4B, an electronic device 300 (e.g., the electronic device 300 of FIG. 3) may include a first plate 311, a second plate 321, a display 303, a guide frame 325, and/or a supporting structure 330.

The configuration of the first plate 311, the second plate 321, the display 303, the guide frame 325 and/or the supporting structure 330 of FIGS. 4A and 4B may be identical in whole or part to the configuration of the first plate 311, the second plate 321, the display 303, the guide frame 325 and/or the supporting structure 330 of FIG. 3.

FIG. 4A illustrates a closed state of the electronic device 300. FIG. 4B illustrates an opened state of the electronic device 300.

When the electronic device 300 changes from the closed state (e.g., FIG. 4A) to the opened state (e.g., FIG. 4B), the first plate 311 may slide in a first sliding direction (e.g., +Y direction of FIGS. 4A and 4B) with respect to the second plate 321. According to an embodiment, at least one portion of the first display area A1 (e.g., the first display area A1 of FIG. 3) may be coupled to at least a portion 311d of the first plate 311. The first display area A1 may slide along with the first plate 311.

When the electronic device 300 is in the closed state (e.g., FIG. 4A), the second display area A2 may have a shape in which at least a portion thereof is rolled up. According to an embodiment, when the electronic device 300 changes from the closed state to the opened state, the second display area A2, along with the first display area A1, may slide in the first sliding direction. The second display area A2 may be supported by a supporting structure 330. The second display area A2 may be supported by the supporting structure 330, and the rolled portion of the second display area A2 may be flattened to form a flat surface with the first display area A1.

According to an embodiment, the supporting structure 330 may be moved along a guide rail (e.g., the guide rail 330 of FIG. 3) coupled to the guide frame 325 and support the second display area A2.

When the electronic device 300 changes from the opened state (e.g., FIG. 4B) to the closed state (e.g., FIG. 4A), the first plate 311 may slide in a second sliding direction (e.g., -Y direction of FIGS. 4A and 4B) with respect to the second plate 321. According to an embodiment, the first display area A1 may slide along with the first plate 311.

When the electronic device 300 is in the opened state (e.g., FIG. 4B), the second display area A2 may have a shape in which at least a portion thereof has been flattened. According to an embodiment, when the electronic device 300 changes from the opened state to the closed state, the second display area A2, along with the first display area A1, may slide in the second sliding direction. The second display area A2 may be supported by the supporting structure 330, and the flattened portion of the second display area A2 may be rolled to form a curved surface with respect to the first display area A1.

According to an embodiment, the second plate 321 may include a front surface 321d that covers the rolled portion of the second display area A2. According to an embodiment, the front surface 321d of the second plate 321 may cover the rolled portion of the second display area A2 to thereby limit exposure of the rolled portion of the second display area A2 to the outside.

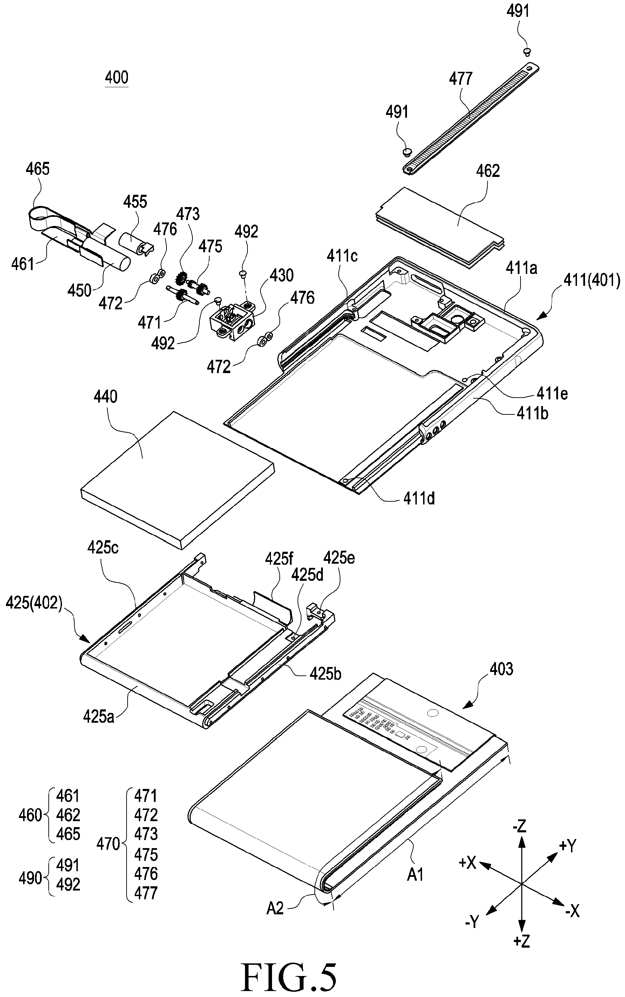

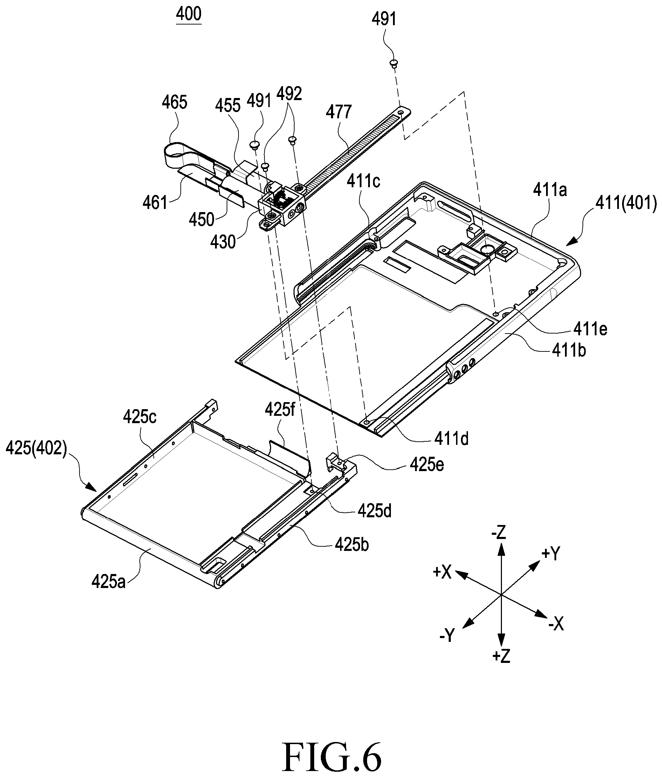

FIG. 5 is an exploded perspective view illustrating an electronic device and a motor structure according to various embodiments of the disclosure. FIG. 6 is a perspective view illustrating a coupling relationship between an electronic device and a motor structure according to various embodiments of the disclosure.

Referring to FIGS. 5 and 6, an electronic device 400 (e.g., the electronic device 300 of FIGS. 3 to 4B) may include a first housing 401, a second housing 402, a display 403, a battery 440, a printed circuit board 460, a flexible printed circuit board 465, a gear frame 430, a motor 450, a driving member 455, a gear structure 470, and/or at least one fastening member 490.

The configuration of the first housing 401, the second housing 402, the display 403, the battery 440, the printed circuit board 460, the motor 450, and the gear structure 470 of FIGS. 5 and 6 may be identical in whole or part to the configuration of the first housing 301, the second housing 302, the display 303, the battery 340, the printed circuit board 360, the motor 351 and the gear structure 352 of FIGS. 3 to 4B.

According to various embodiments, the first housing 401 (e.g., the first housing 301 of FIGS. 3 to 4B) may include a first plate 411 (e.g., the first plate 311 of FIGS. 3 to 4B). According to an embodiment, the first plate 411 may have one surface (e.g., the surface facing in the +Z direction of FIGS. 5 and 6) where the first display area A1 (e.g., the first display area A1 of FIGS. 3 to 4B) may be disposed and the other surface (e.g., the surface facing in the -Z direction of FIGS. 5 and 6) facing in the direction opposite to the one surface where the rack gear 477 may be disposed.

According to various embodiments, the first plate 411 may include a 1-1th sidewall 411a (e.g., the 1-1th sidewall 211a of FIGS. 2Ato 2C), a 1-2th sidewall 411b (e.g., the 1-2th sidewall 211b of FIGS. 2A to 2C), and a 1-3th sidewall 411c (e.g., the 1-3th sidewall 411c of FIGS. 2A to 2C).

According to various embodiments, the second housing 402 (e.g., the second housing 402 of FIGS. 3 to 4B) may include a guide frame 425 (e.g., the guide frame 325 of FIGS. 3 to 4B) (e.g., a frame cover).

According to an embodiment, the guide frame 425 may include a 3-1th sidewall 425a facing at least one portion (e.g., a rolled portion) of the second display area A2 (e.g., the second display area A2 of FIG. 3) of the display 403 (e.g., the display 303 of FIG. 3). In an embodiment, the 3-1th sidewall 425a may face in a direction (e.g., the -Y direction of FIGS. 5 and 6) opposite to the 1-1th sidewall 411a and may have at least a portion which has a curved shape in the portion facing the second display area A2.

According to an embodiment, the guide frame 425 may include a 3-2th sidewall 425b extending from the 3-1th sidewall 425a and a 3-3th sidewall 425c extending from the 3-1th sidewall 425a and spaced apart from the 3-2th sidewall 425b. According to an embodiment, when the electronic device 400 is in the closed state (e.g., FIG. 2A), at least a portion of the 3-2th sidewall 425b may face the 1-2th sidewall 411b, and at least a portion of the 3-3th sidewall 425c may face the 1-3th sidewall 411c. For example, when the electronic device 400 is in the closed state (e.g., FIG. 2A), the 1-2th sidewall 411b may cover at least a portion of the 3-2th sidewall 425b, and the 1-3th sidewall 411c may cover at least a portion of the 3-3th sidewall 425c.

According to an embodiment, in the guide frame 425, the battery 440 (e.g., the battery 340 of FIGS. 3 to 4B) may be disposed in a recess formed in the guide frame 425. According to an embodiment, the guide frame 425 may be coupled to the gear frame 430.

According to various embodiments, the display 403 (e.g., the display 303 of FIG. 3) may include a first display area A1 (e.g., the first display area A1 of FIG. 3) and a second display area A2 (e.g., the second display area A2 of FIG. 3) extending from the first display area A1. According to an embodiment, when the electronic device 400 is in the closed state (e.g., FIG. 2A), at least a portion of the second display area A2 may be disposed to cover at least a portion of the guide frame 425 and/or at least a portion of the battery 440.

According to an embodiment, when the electronic device 400 is in the closed state (e.g., FIG. 2A), one surface (e.g., the surface facing in the -Z direction of FIGS. 5 and 6) of the first display area A1 may face one surface (e.g., the surface facing in the +Z direction of FIGS. 5 and 6) of the first plate 411, the other surface (e.g., the surface facing in the -Z direction of FIGS. 5 and 6) of the first plate 411 may face one surface e.g., the surface facing in the +Z direction of FIGS. 5 and 6) of the guide frame 425, and the other surface (e.g., the surface facing in the -Z direction of FIGS. 5 and 6) of the guide frame 425 and/or one surface (e.g., the surface facing in the -Z direction of FIGS. 5 and 6) of the battery 440 (e.g., the battery 340 of FIG. 3) may face one surface (e.g., the surface facing in the +Z direction of FIGS. 5 and 6) of the flat portion of the second display area A2. According to an embodiment, one surface (e.g., the surface facing in the +Z direction of FIGS. 5 and 6) of the second display area A2 may face one surface (e.g., the surface facing in the -Z direction of FIG. 3) of the battery plate (e.g., the battery plate 327 of FIG. 3).

According to an embodiment, at least a portion of the rolled portion of the second display area A2 may face the 3-1th sidewall 425a of the guide frame 425. According to an embodiment, the second display area A2 and the supporting structure (e.g., the supporting structure 330 of FIG. 3) supporting the second display area A2 may be slid while being supported by the 3-1th sidewall 425a when the electronic device 400 is opened or closed. For example, when the first display area A1 slides in the first sliding direction (e.g., the +Y direction of FIGS. 5 and 6), the second display area A2 may be supported by the 3-1th sidewall 425a and, as the rolled portion of the second display area A2 is unrolled, the second display area A2, together with the first display area A1, may form a substantially flat surface.

According to various embodiments, the printed circuit board 460 (e.g., the printed circuit board 360 of FIG. 3) may include a first printed circuit board 461 (e.g., the first printed circuit board 361 of FIG. 3), a second printed circuit board 462 (e.g., the second printed circuit board 462 of FIG. 3) and a flexible circuit board 465.

According to various embodiments, the first printed circuit board 461 may be disposed in the second housing 402. According to an embodiment, the first printed circuit board 461 may be disposed on the guide frame 425. According to another embodiment, the first printed circuit board 461 may be disposed on the second plate (e.g., the second plate 321 of FIG. 3).

According to an embodiment, the first printed circuit board 461 may be a power PCB configured to transfer the power supplied from the battery 440 to the motor 450 or the driving member 455. In an embodiment, the first printed circuit board 461 may be electrically connected to the battery 440, the motor 450, or the driving member 455 through a conductive wire or FPCB.

According to various embodiments, the second printed circuit board 462 may be disposed in the first housing 401. According to an embodiment, the second printed circuit board 462 may be disposed in the first plate 411.

According to an embodiment, a processor, a memory, and/or an interface may be mounted on the second printed circuit board 462. The processor may include one or more of, e.g., a central processing unit, an application processor, a graphic processing device, an image signal processing, a sensor hub processor, or a communication processor.

According to various embodiments, the flexible circuit board 465 may include at least one of a flexible PCB (FPCB) and a rigid-flexible PCB (RFPCB). According to an embodiment, the processor may control the operation of the motor 450 or the driving member 455 through the printed circuit board 460.

According to various embodiments, the gear frame 430 may be coupled to at least a portion of the guide frame 425. According to an embodiment, the gear frame 430 may be coupled to a portion adjacent to the 1-2th sidewall 425b of the guide frame 425. According to an embodiment, the gear frame 430 may have a box shape having an internal space and a side opening. According to an embodiment, the gear frame 430 may further include coupling portions respectively formed on one surface (e.g., the surface facing in the +Y direction of FIGS. 5 and 6) of the gear frame 430 and the other surface (e.g., the surface facing in the -Y direction of FIGS. 5 and 6) of the gear frame 430. According to an embodiment, the second fastening members 492 (e.g., bolts or pins) may be coupled through the pair of coupling portions, allowing the gear frame 430 to be coupled to the guide frame 425. For example, a pair of second fastening members 492 may be coupled and/or fastened to a pair of coupling holes 425d and 425e formed in the guide frame 425, fixing the gear frame 430 to the guide frame 425.

According to an embodiment, the gear frame 430 may receive at least a portion of the gear structure 470. According to an embodiment, the gear frame 430 may receive at least a portion of the first gear portion 471, the second gear portion 473, and the third gear portion 475. According to an embodiment, the gear frame 430 may further include through holes respectively formed in one surface (e.g., the surface facing in the +Y direction of FIGS. 5 and 6) of the gear frame 430 and the other surface (e.g., the surface facing in the -Y direction of FIGS. 5 and 6) of the gear frame 430 and having positions corresponding to each other. According to an embodiment, at least a portion of the rack gear 477 may be inserted into the gear frame 430. When the rack gear 477 slides, at least a portion thereof may be slid in the through hole of the gear frame 430 and the gear frame 430.

According to an embodiment, the gear frame 430 may rotatably support the first gear portion 471 and/or the third gear portion 475. According to an embodiment, the gear frame 430 may rotatably support the first gear portion 471 and/or the third gear portion 475. For example, the gear frame 430 is coupled with a first bearing 472 and/or a second bearing 476. The first bearing 472 may rotatably support the shaft of the first gear portion 471, and the second bearing 476 may rotatably support the shaft of the third gear portion 475.

According to various embodiments, the motor 450 (e.g., the motor 361 of FIG. 3) may be disposed in or coupled to the second housing 402. According to an embodiment, the motor 450 may be seated or disposed in a space formed by the seating portion 425f of the guide frame 425. In an embodiment, the seating portion 425f may be formed to protrude from at least a portion of the guide frame 425, and provide a space in which the motor 450 may be seated. According to an embodiment, the motor 450 may provide a driving force for sliding the first housing 401 (e.g., the first plate 411 of FIGS. 5 and 6).

According to an embodiment, the motor 450 may be connected or coupled with the first gear portion 471. According to an embodiment, the motor 450 may rotate the first gear portion 471 in one direction or rotate the first gear portion 471 in another direction opposite to the one direction.

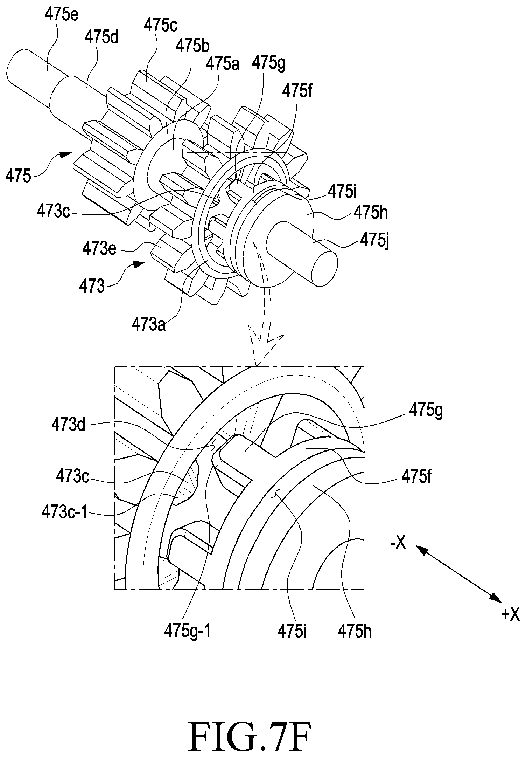

According to various embodiments, the driving member 455 may be disposed in or coupled to the second housing 402. According to an embodiment, the driving member 455 may be coupled to the seating portion 425f of the guide frame 425. For example, at least one portion of the driving member 455 may be coupled to one surface (e.g., the surface facing in the +Y direction of FIGS. 5 and 6) of the seating portion 425f. According to an embodiment, at least a portion of the driving member 455 may be connected to at least a portion of the third gear portion 475. According to an embodiment, the driving member 455 may provide a driving force for sliding at least a portion of the gear structure 470. For example, the driving member 455 may slide at least a portion (e.g., the 3-1th gear 475g of FIG. 7F) of the third gear portion 475 closer to the second gear portion 473 (e.g., the -X direction of FIGS. 5 and 6) or away from the second gear portion 473 (e.g., the +X direction of FIGS. 5 and 6).

According to various embodiments, the gear structure 470 may be disposed in the housings 401 and 402. According to an embodiment, the gear structure 470 may be configured to transfer the driving force provided from the motor 450 to the first housing 401 (e.g., the first plate 411).

According to various embodiments, the gear structure 470 includes a first gear portion 471, a second gear portion 473, a third gear portion 475 and a rack gear 477. According to various embodiments, the gear structure 470 may include a first bearing 472 and/or a or a second bearing 476.

According to an embodiment, the first gear portion 471 may be defined and interpreted as a gear assembly in which a gear and a shaft are coupled, assembled or integrally formed. According to an embodiment, the second gear portion 473 may be defined and interpreted as a gear assembly in which a gear and a shaft are coupled, assembled or integrally formed. According to an embodiment, the third gear portion 475 may be defined and interpreted as a gear assembly in which a gear and a shaft are coupled, assembled or integrally formed.

According to various embodiments, the first gear portion 471 may be connected to the motor 450 and may be configured to be rotated by the motor 450. According to an embodiment, in the first gear portion 471, the shaft of the first gear portion 471 may be rotatably coupled or connected to the gear frame 430 through the first bearing 472. According to an embodiment, at least a portion of the first gear portion 471 may be connected to the second gear portion 473.

According to various embodiments, at least a portion of the second gear portion 473 may be connected with the first gear portion 471. According to an embodiment, the second gear portion 473 may be disposed on the shaft of the third gear portion 475, and at least a portion thereof may be connected to or disconnected from at least a portion of the third gear portion 475. In an embodiment, when at least a portion of the second gear portion 473 is connected to at least a portion of the third gear portion 475, the driving force provided from the motor 450 may be transferred through the first gear portion 471 and the second gear portion 473 to the third gear portion 475.

According to various embodiments, at least a portion of the third gear portion 475 is connected to or disconnected from at least a portion of the second gear portion 473, and the rest may be connected to the rack gear 477. According to an embodiment, in the third gear portion 475, the shaft of the third gear portion 475 may be rotatably coupled or connected to the gear frame 430 through the second bearing 476. In an embodiment, when at least a portion of the third gear portion 475 is connected to at least a portion of the second gear portion 473, the driving force provided from the motor 450 may be transferred through the first gear portion 471, the second gear portion 473, and the third gear portion 475 to the rack gear 477.

According to various embodiments, the rack gear 477 is disposed in or coupled to the first housing 401 (e.g., the first plate 411 of FIGS. 5 to 6). According to an embodiment, two opposite ends of the rack gear 477 may be coupled to the first plate 411 by a pair of first fastening members 491. According to an embodiment, the pair of first fastening members 491 respectively may pass through two opposite ends of the rack gear 477 and be coupled and/or fixed to the pair of coupling holes 411d and 411e formed in the first plate 411, thereby fixing the rack gear 477 to the first plate 411. According to an embodiment, the rack gear 477 is connected or coupled to at least a portion of the third gear portion 475 and, by the rotation of the third gear portion 475, may be slid in the first sliding direction (e.g., the +Y direction of FIGS. 5 and 6) or in the second sliding direction (e.g., the -Y direction of FIGS. 5 and 6) opposite to the first sliding direction. In an embodiment, the first plate 411, along with the rack gear 477, may be slid.

According to an embodiment, the at least one fastening member 490 may include a first fastening member 491 for fixing the rack gear 477 to the first plate 411 and a second fastening member 492 for fixing the gear frame 430 to the guide frame 425.

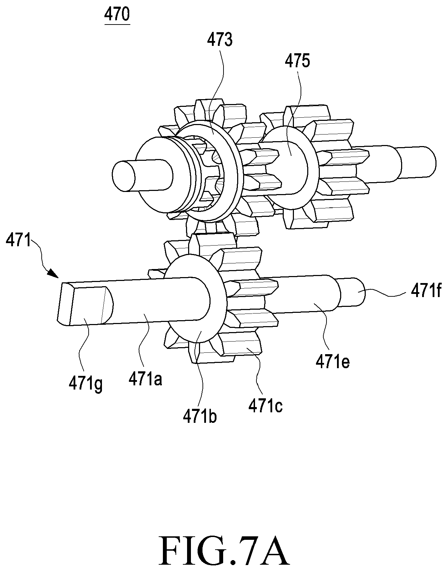

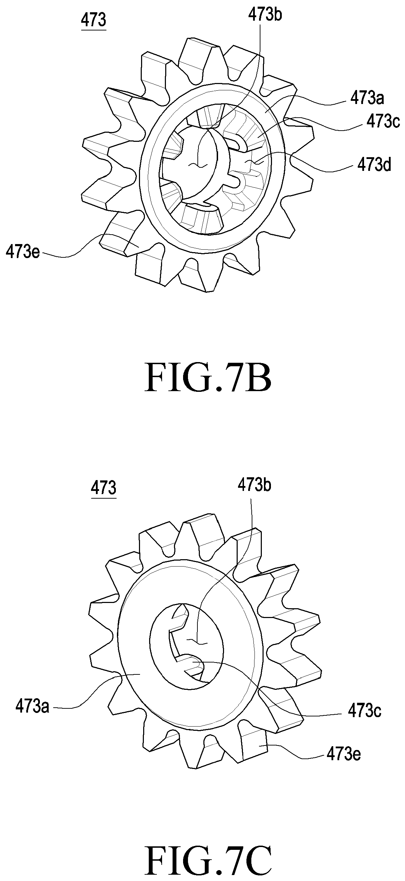

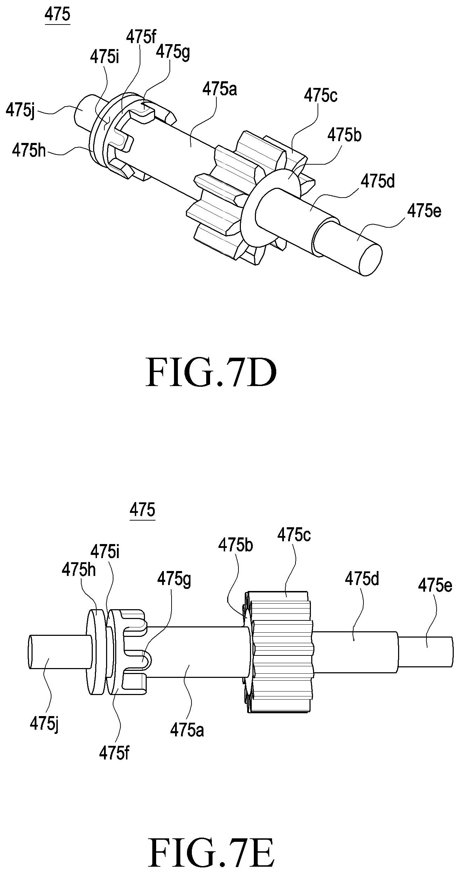

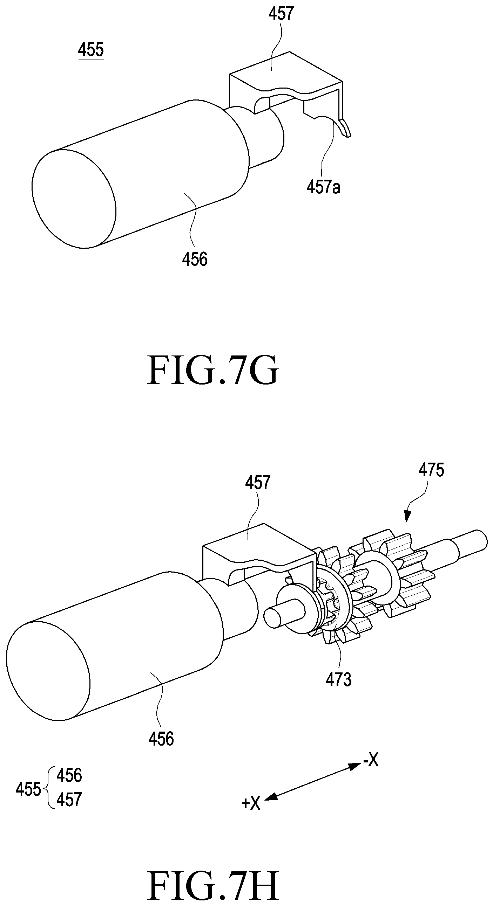

FIG. 7A is a perspective view illustrating a coupled state of a gear structure according to various embodiments of the disclosure. FIG. 7B is a perspective view illustrating a second gear portion according to various embodiments of the disclosure. FIG. 7C is a perspective view illustrating the second gear portion as viewed in a direction different from that of FIG. 7B, according to various embodiments of the disclosure. FIG. 7D is a perspective view illustrating a third gear portion according to various embodiments of the disclosure. FIG. 7E is a perspective view illustrating the third gear portion as viewed in a direction different from that of FIG. 7D, according to various embodiments of the disclosure. FIG. 7F is a perspective view illustrating a coupling relationship between a second gear portion and a third gear portion according to various embodiments of the disclosure. FIG. 7G is a perspective view illustrating a driving member according to various embodiments of the disclosure. FIG. 7H is a perspective view illustrating a coupling relationship between a driving member and a gear structure according to various embodiments of the disclosure;

Referring to FIGS. 7A to 7H, the gear structure 470 may include a first gear portion 471, a second gear portion 473, and/or a third gear portion 475.

The configuration of the gear structure 470, the first gear portion 471, the second gear portion 473 and/or the third gear portion 475 of FIGS. 7A to 7H may be identical in whole or part to the configuration of the gear structure 470, the first gear portion 471, the second gear portion 473, and/or the third gear portion 475 of FIGS. 5 and 6.

According to various embodiments, the first gear portion 471 may include a shaft 471a, 471e, and 471f, a first body portion 471b and/or a 1-1th gear 471c.

According to various embodiments, in the first gear portion 471, the first body portion 471b may be coupled or connected to the shaft 471a, 471e, and 471f. In an embodiment, the shaft 471a, 471e, and 471f of the first gear portion 471 may extend in a straight line. In an embodiment, the shaft 471a, 471e, and 471f of the first gear portion 471 may include a 1-1th shaft portion 471a extending in one direction with respect to the first body portion 471b, a 1-2th shaft portion 471e extending in the other direction opposite to the one direction with respect to the first body portion 471b, and a 1-3th shaft portion 471f extending from the 1-2th shaft portion 471e. According to an embodiment, the 1-1th shaft portion 471a, the 1-2th shaft portion 471e, and the 1-3th shaft portion 471f may be integrally formed or manufactured. According to another embodiment, the 1-1th shaft portion 471a, the 1-2th shaft 471e, and the 1-3th shaft portion 471f may be formed or manufactured as separate members and be assembled.

According to an embodiment, the 1-1th shaft portion 471a may include a first insertion portion 471g with at least one angled or flat portion. The first insertion portion 471g may be inserted into the motor (e.g., the motor 450 of FIGS. 5 and 6). In an embodiment, as the motor rotates the first insertion portion 471g, the first gear portion 471 may be rotated in one direction or in the other direction which is opposite to the one direction. In an embodiment, at least a portion of the 1-1th shaft portion 471a may be rotatably supported on the gear frame (e.g., the gear frame 430 of FIGS. 5 and 6) by a first bearing (e.g., the first bearing 472 of FIGS. 5 and 6).

According to an embodiment, the 1-3th shaft portion 471f may be disposed on or coupled to one end of the 1-2th shaft portion 471e. According to an embodiment, the 1-2th shaft portion 471e may have a larger diameter than the 1-3th shaft portion 471f. According to an embodiment, the 1-3th shaft portion 471f may be rotatably supported on the gear frame (e.g., the gear frame 430 of FIGS. 5 and 6) by a first bearing (e.g., the first bearing 472 of FIGS. 5 and 6).

According to an embodiment, the first body portion 471b may have a circular plate shape having any (or designated) thickness and any (or designated) diameter. According to an embodiment, the 1-1th gear 471c may be coupled to the outer circumferential surface of the first body portion 471b. According to an embodiment, the 1-1th gear 471c may be provided with a plurality of gear teeth spaced apart at equal intervals or at designated intervals along the outer circumferential surface of the first body portion 471b.

According to an embodiment, the 1-1th gear 471c may be connected to the 2-1th gear 473e of the second gear portion 473. According to an embodiment, when the first gear portion 471 is rotated, the second gear portion 473 connected with the first gear portion 471 may be rotated. In an embodiment, the driving force provided from the motor may be transferred to the 2-1th gear 473e and the second gear portion 473 through the 1-1th gear 471c.

According to various embodiments, the second gear portion 473 may include a second body portion 473a, a through portion 473b, a 2-1th gear 473e, and/or a 2-2th gear 473c.

According to an embodiment, the second body portion 473a may have a circular plate shape. According to an embodiment, the 2-1th gear 473e may be disposed or coupled to the outer circumferential surface of the second body portion 473a.

According to an embodiment, the second gear portion 473 may include a through portion 473b formed through at least one portion of the second body portion 473a. According to an embodiment, the through portion 473b may be defined and interpreted as a hole or space formed through the second body portion 473a. **In** an embodiment, the 3-1th shaft portion 475a of the third gear portion 475 may be disposed in the through portion 473b. For example, the 3-1th shaft portion 475a may be slidably coupled to the through portion 473b.

According to an embodiment, the second body portion 473a may include a recess from one surface (e.g., the surface shown in FIG. 7B or the surface facing in the +X direction of FIG. 7F) to the other surface (e.g., the surface shown in FIG. 7C or the surface facing in the -X direction of FIG. 7C). According to an embodiment, the recess formed in the second body portion 473a and the through portion 473b formed in the second body portion 473a may be defined and interpreted as spaces connected to each other in a spatial configuration. In an embodiment, the recess and through portion 473b may be defined and interpreted as different spaces. In another embodiment, the recess and through portion 473b may be defined and interpreted as substantially the same space or one space. In an embodiment, the through portion 473b may be defined and interpreted as a hole formed through at least a portion of the bottom surface, of the recess formed in the second body portion 473a.

According to an embodiment, the recess and/or through portion 473b of the second body portion 473a may provide a space in which the 3-1th shaft portion 475a of the third gear portion 475 may be disposed, and the recess of the second body portion 473a may provide a space in which the 3-1th gear 475g of the third gear portion 475 may be inserted.

According to various embodiments, the 2-1th gear 473e may be disposed or coupled to the outer circumferential surface of the second body portion 473a. In an embodiment, the 2-1th gear 473e may be defined and interpreted as being disposed on the outside of the second gear portion 473. According to an embodiment, the 2-1th gear 473e may be provided with a plurality of gear teeth spaced apart at equal intervals or at designated intervals along the outer circumferential surface of the second body portion 473a. According to an embodiment, the 2-1th gear 473e may be connected to the 1-1th gear 471c. For example, the 2-1th gear 473e may mesh with the 1-1th gear 471c. As the first gear portion 471 rotates in one direction or the other direction opposite to the one direction, the second gear portion 473 may be rotated in the other direction or the one direction. In an embodiment, the second gear portion 473 may receive the driving force of the motor through the first gear portion 471 and transfer the received driving force to the third gear portion 475.

According to various embodiments, the 2-2th gear 473c may be disposed and/or coupled to an inner circumferential surface of the second body portion 473a that forms a side surface of the recess of the second body portion 473a. In an embodiment, the 2-2th gear 473c may be formed to protrude from the inner circumferential surface of the second body portion 473a toward the center of the second body portion 473a. In an embodiment, the 2-2th gear 473c may be defined and interpreted as being disposed on the inside of the second gear portion 473. According to an embodiment, the 2-2th gear 473c may be provided with a plurality of gear teeth spaced apart at equal intervals or at designated intervals along the inner circumferential surface of the second body portion 473a. According to an embodiment, the 2-2th gear 473c may be configured to be connected to or disconnected from the 3-1th gear 475g.

According to an embodiment, when the 2-2th gear 473c is connected with the 3-1th gear 475g, the driving force of the motor 450 may be transmitted through the first gear portion 471 and the second gear portion 473 to the third gear portion 475. The driving force transferred to the third gear portion 475 may be transferred to the rack gear (e.g., the rack gear 477 of FIGS. 5 and 6). According to an embodiment, when the 2-2th gear 473c is disconnected from the 3-1th gear 475g, the motor (e.g., the motor 450 of FIGS. 5 and 6) and the first gear portion 471 may be configured not to be dynamically connected to the rack gear (e.g., the rack gear 477 of FIGS. 5 and 6).

According to an embodiment, the motor (e.g., the motor 450 of FIGS. 5 and 6) and the first gear portion 471 may be dynamically connected to the rack gear (e.g., the rack gear 477 of FIGS. 5 and 6) when the 3-1th gear 475g is connected with the 2-2th gear 473c.

According to an embodiment, a plurality of gear teeth spaced apart from each other of the 2-2th gear 473c may have a second insertion portion 473d which is a spacing between adjacent gear teeth of the 2-2th gear 473c in the plurality of gear teeth spaced apart from each other. In an embodiment, there may be provided second insertion portions 473d. In an embodiment, the plurality of second insertion portions 473d may be defined and interpreted as spaces into which the 3-1th gear 475g (or the plurality of gear teeth of the 3-1th gear 475g) is inserted. For example, the state in which the 3-1th gear 475g is inserted into the second insertion portion 473d may be defined and interpreted as a state in which the 3-1th gear 475g and the 2-2th gear 473c are connected.

According to various embodiments, the third gear portion 475 may include a 3-1th gear 475g, a 3-2th gear 475c, a shaft 475a, 475d, 475e, and 475j, a third body portion 475b, a first circular plate 475f, and a second circular plate 475h.

According to various embodiments, the shaft 475a, 475d, 475e, and 475j of the third gear portion 475 may include a 3-1th shaft portion 475a, a 3-2th shaft portion 475d, a 3-3th shaft portion 475e, and a 3-4th shaft portion 475j. According to an embodiment, the 3-1th shaft portion 475a, the 3-2th shaft portion 475d, the 3-3th shaft portion 475e, and the 3-4th shaft portion 475j may be integrally formed or manufactured. According to another embodiment, the 3-1th shaft portion 475a, the 3-2th shaft portion 475d, the 3-3th shaft portion 475e, and the 3-4th shaft portion 475j are formed or manufactured as separate members and be assembled.

According to an embodiment, the 3-1th shaft portion 475a may have a cylindrical shape having a designated length and a designated diameter. The third body portion 475b, the first circular plate 475f, and the second circular plate 475h may be spaced apart from each other along the length direction of the 3-1th shaft portion 475a, disposed, and/or coupled on the outer circumferential surface of the 3-1th shaft portion 475a. According to an embodiment, the second gear portion 473 may be disposed on the 3-1th shaft portion 475a of the third gear portion 475. For example, the through portion 473b of the second gear portion 473 may have a 3-1th shaft portion 475a disposed therein. In an embodiment, when the second gear portion 473 is rotated in one direction or the other direction while being connected with the third gear portion 475, the third gear portion 475 may be rotated in the one direction or the other direction. In an embodiment, when the second gear portion 473 is rotated in one direction or the other direction while being disconnected from the third gear portion 475, the third gear portion 475 may not be rotated. Further, when the third gear portion 475 is rotated by the rack gear 477 with the second gear portion 473 disconnected from the third gear portion 475, the second gear portion 473 may not be rotated. In an embodiment, if the third gear portion 475 is rotated with the second gear portion 473 disconnected from the third gear portion 475, the 3-1th shaft portion 475a may be rotated relative to the second gear portion 473 or freely rotated in the through portion 473a of the second gear portion 473. In an embodiment, the second gear portion 473 may be positioned between the 3-1th gear 475g and the 3-2th gear 475c, on the 3-1th shaft portion 475a.

According to an embodiment, the third body portion 475b may be disposed at one end of the 3-1th shaft portion 475a. In an embodiment, the third body portion 475b may have a circular plate shape having any (or designated) thickness and any (or designated) diameter.

According to an embodiment, the first circular plate 475f may be disposed adjacent to the other end opposite to the one end of the 3-1th shaft portion 475b. In an embodiment, the first circular plate 475f may have a circular plate shape having any (or designated) thickness and any (or designated) diameter.

According to an embodiment, the second circular plate 475h may be disposed at the other end of the 3-1th shaft portion 475b. For example, the first circular plate 475f may be disposed between the second circular plate 475h and the third body portion 475b, on the 3-1th shaft portion 475a and may be disposed substantially closer to the second circular plate 475h than to the third body portion 475b.

According to an embodiment, the first circular plate 475f and the second circular plate 475h may be spaced apart by a designated (or any) distance, so that the third insertion portion 475i which is a spacing may be formed therebetween. At least a portion of the switch portion 457 of the driving member 455 may be inserted into the third insertion portion 475i. In an embodiment, with the switch portion 457 inserted into the third insertion portion 475i, the switch portion 457 may pressurize the first circular plate 475f or the second circular plate 475h.

According to an embodiment, the 3-1th gear 475g may be connected to the first circular plate 475f. For example, the 3-1th gear 475g may be formed to protrude from one surface (e.g., the surface facing in the -X direction of FIG. 7F) of the first circular plate 475f toward the third body portion 475b or the second gear portion 473. The 3-1th gear 475g may be provided with a plurality of gear teeth spaced apart at equal intervals or designated intervals along the circumference or edge of the first circular plate 475f. In an embodiment, the 3-1th gear 475g may be engaged and connected with the 2-2th gear 473c or may be spaced apart and disconnected from the 2-2th gear 473c. In a state in which the 3-1th gear 475g and the 2-2th gear 473c are connected, the third gear portion 475 may be rotated by the second gear portion 473. In an embodiment, when the second gear portion 473 is rotated in one direction or the other direction opposite to the one direction, the third gear portion 475, together with the second gear portion 473, may be rotated in the one direction or the other direction.

According to various embodiments, the 3-2th shaft portion 475d may be disposed or coupled to one surface (e.g., the surface facing in the -X direction in FIG. 7F) of the third body portion 475b. According to an embodiment, the 3-2th shaft portion 475d may be defined and interpreted as being disposed or coupled to one end of the 3-1th shaft portion 475a. In an embodiment, the 3-2th shaft portion 475d may have a cylindrical shape with any (or designated) length and any (or designated) diameter. In an embodiment, the 3-2th shaft portion 475d may have a smaller diameter than the 3-1th shaft portion 475a. In another embodiment, the 3-2th shaft portion 475d may have substantially the same diameter as the 3-1th shaft portion 475a or may have a larger diameter than the 3-1th shaft portion 475a.

According to various embodiments, the 3-3th shaft portion 475e may be disposed or coupled to one end of the 3-2th shaft portion 475d. According to an embodiment, the 3-2th shaft portion 475e may have a cylindrical shape with any (or designated) length and any (or designated) diameter. In an embodiment, the 3-3th shaft portion 475e may have a smaller diameter than the 3-2th shaft portion 475d. In an embodiment, the 3-3th shaft portion 475e may be defined and interpreted as a portion rotatably supported by a second bearing (e.g., the second bearing 476 of FIG. 5). The 3-3th shaft portion 475e may have substantially the same diameter as the hole of the second bearing or may have a smaller diameter than the hole of the second bearing. In an embodiment, the 3-2th shaft portion 475d may have a larger diameter than the hole of the second bearing. In an embodiment, when the third gear portion 475 slides, the 3-2th shaft portion 475d may not be inserted into the hole of the second bearing, so that the sliding distance of the third gear portion 475 may be limited.

According to various embodiments, the 3-4th shaft part 475j may be disposed or coupled to the other end of the 3-1th shaft portion 475a. According to an embodiment, the 3-4th shaft portion 475j may have a cylindrical shape with any (or designated) length and any (or designated) diameter. In an embodiment, the 3-4th shaft portion 475j may have a smaller diameter than the 3-1th shaft portion 475a. In an embodiment, the 3-4th shaft portion 475j may be defined and interpreted as a portion rotatably supported by a second bearing (e.g., the second bearing 476 of FIG. 5). The 3-4th shaft portion 475j may have substantially the same diameter as the hole of the second bearing or may have a smaller diameter than the hole of the second bearing. In an embodiment, the 3-1th shaft portion 475a may have a larger diameter than the hole of the second bearing. In an embodiment, when the third gear portion 475 slides, the 3-1th shaft portion 475a or the second circular plate 475h may not be inserted into the hole of the second bearing, so that the sliding distance of the third gear portion 475 may be limited.

According to an embodiment, the 3-2th gear 475c may be disposed or coupled to the outer circumferential surface of the third body portion 475b. The 3-2th gear 475c may be provided with a plurality of gear teeth spaced apart at equal intervals or at designated intervals along the outer circumferential surface of the third body portion 475b. In an embodiment, the 3-2th gear 475c may be connected with a rack gear (e.g., the rack gear 477 of FIGS. 5 and 6). According to an embodiment, the third gear portion 475 may transfer the driving force of the motor (e.g., the motor 450 of FIGS. 5 and 6) transferred through the first gear portion 471 and the second gear portion 473 to the rack gear.

Referring to FIG. 7F, the 3-1th gear 475g may include a first inclined surface 475g-1 formed to be inclined at at least a portion of each gear tooth of the 3-1th gear 475g. The 2-2th gear 473c may include a second inclined surface 473c-1 formed to be inclined at at least a portion of each gear tooth of the 2-2th gear 473c. In an embodiment, the first inclined surface 475g-1 may be formed at the edge portion or angled portion of each gear tooth of the 3-1th gear 475g. The second inclined surface 473c-1 may be formed at the edge portion or angled portion of each gear tooth of the 2-2th gear 473c. For example, to connect the third gear portion 475 and the second gear portion 473, the third gear portion 475 may be slid in a third sliding direction (e.g., the -X direction in FIG. 7F). When the second gear portion 473 and the third gear portion 475 are connected, each gear tooth of the 3-1th gear 475g may be inserted into the second insertion portion 475d of the second gear portion 473. In an embodiment, even when at least a portion of the 3-1th gear 475g overlaps the 2-2th gear 473c in the sliding direction (e.g., the X-axis direction of FIG. 7F), the 3-1th gear 475g may be slid on the 2-2th gear 473c through the first inclined surface 475g-1 and the second inclined surface 473c-1 and be more smoothly inserted into the second insertion portion 473d. In an embodiment, the first inclined surface 475g-1 may be formed to have a slope of about 10 degrees to about 80 degrees from one surface (e.g., the surface facing in the -X direction of FIG. 7F) of the gear tooth of the 3-1th gear 475g. For example, the slope of the first inclined surface 475g-1 may be about 45 degrees. In an embodiment, the second inclined surface 473c-1 may be formed to have a slope of about 10 degrees to about 80 degrees from one surface (e.g., the surface facing in the +X direction of FIG. 7F) of the gear tooth of the 2-2th gear 473c. For example, the slope of the second inclined surface 473c-1 may be about 45 degrees.

According to various embodiments, the driving member 455 may include a solenoid 456 and a switch portion 457 configured to reciprocate from the solenoid 456 toward the second gear portion 473.

According to an embodiment, the solenoid 456 may convert the electric power (or electrical energy) supplied from a battery (e.g., the battery 440 of FIGS. 5 and 6) into magnetic energy and provide a driving force for linear reciprocation of the switch portion 457.

According to an embodiment, the solenoid 456 may include a case, a coil disposed in the case and at least a portion of which is coiled, a plunger disposed in the coiled coil, and a return spring at least a portion of which is connected to the plunger. **In** an embodiment, the coil is configured to flow a current through the supplied power, and a magnetic force may be formed or generated inside the coiled coil. In an embodiment, the plunger may be slid in a third sliding direction (e.g., the -X direction of FIG. 7H) on the case through the generated magnetic force. In an embodiment, the return spring may provide an elastic restoring force to the plunger so that the plunger returns to its original position in a state in which the magnetic force is removed. In an embodiment, the return spring may provide an elastic restoring force so that the plunger slides in the fourth sliding direction (e.g., the +X direction of FIG. 7H). In an embodiment, the plunger may be connected and/or coupled with the switch portion 457. The switch portion 457 may slide along with the plunger. In an embodiment, the switch portion 457 may be interpreted as a component of the plunger.

According to an embodiment, the solenoid may include various means for sliding the switch portion 457 in the third sliding direction (e.g., the -X direction of FIG. 7H) or the fourth sliding direction (e.g., the +X direction of FIG. 7H) opposite to the third sliding direction.

According to an embodiment, the switch portion 457 may slide in a linear direction or the sliding direction (e.g., the X-axis direction of FIG. 7H). According to an embodiment, the switch portion 457 may include a bent portion not to overlap a portion of the gear frame (e.g., the gear frame 430 of FIGS. 5 and 6). The switch portion 457 may include a curved portion 457a in at least a portion thereof. **In** an embodiment, the curved portion 457a may be a recessed portion to have any (or designated) curvature. According to an embodiment, at least a portion of the switch portion 457 may be inserted into the third insertion portion 475i. In an embodiment, the curved portion 457a may face at least a portion of the 3-1th shaft portion 475a. In an embodiment, the switch portion 457 may be fixed to the third insertion portion 475j.

In an embodiment, the switch portion 457 may slide in the third sliding direction (e.g., the -X direction of FIG. 7H), pressurizing at least a portion of the first circular plate 475f of the third gear portion 475. In an embodiment, the third gear portion 475 may be pressurized by the switch portion 457 in the third sliding direction (e.g., the -X direction of FIG. 7H) to be slid in the third sliding direction, and the 3-1th gear 475g may be inserted into the second insertion portion 473d, and the 3-1th gear 475g and the 2-2th gear 473c may be connected to each other.

In an embodiment, the switch portion 457 may slide in the fourth sliding direction (e.g., the +X direction of FIG. 7H), pressurizing at least a portion of the second circular plate 475h of the third gear portion 475. In an embodiment, the third gear portion 475 may be pressurized by the switch portion 457 in the fourth sliding direction (e.g., the +X direction of FIG. 7H) to be slid in the third sliding direction, and the 3-1th gear 475g may be removed from the second insertion portion 473d, and the 3-1th gear 475g and the 2-2th gear 473c may be disconnected from each other.

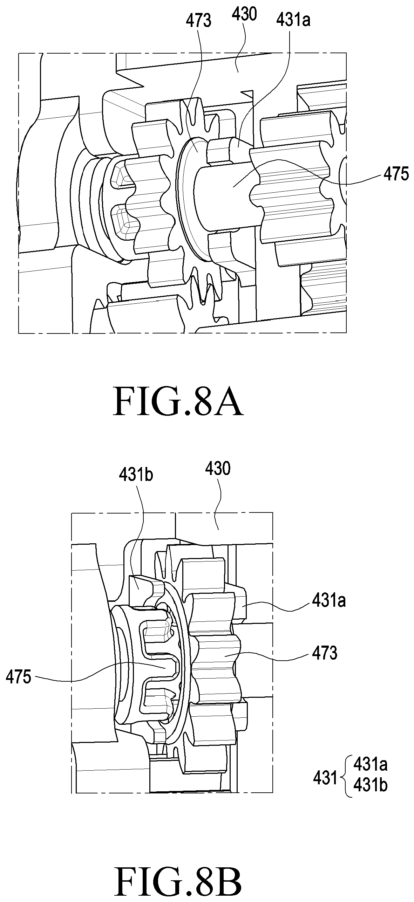

FIG. 8A is a perspective view illustrating a coupling relationship between a gear structure and a gear frame according to various embodiments of the disclosure. FIG. 8B is a perspective view illustrating a coupling relationship between the gear structure and the gear frame as viewed in a direction different from that of FIG. 8A, according to various embodiments of the disclosure.

Referring to FIGS. 8A and 8B, an electronic device (e.g., the electronic device 400 of FIGS. 5 and 6) may include a gear frame 430, a second gear portion 473, and a third gear portion 475.

The configuration of the gear frame 430, the second gear portion 473 and the third gear portion 475 of FIGS. 8A and 8B may be identical in whole or part to the configuration of the gear frame 430, the second gear portion 473 and the third gear portion 475 of FIGS. 5 to 7H.

According to various embodiments, the gear frame 430 may include a stopper 431 protruding or extending from at least a portion of the gear frame 430. According to an embodiment, the stopper 431 may be configured to restrict the sliding movement of the second gear portion 473. According to an embodiment, the stopper 431 may restrict the sliding movement of the second gear portion 473 in the sliding direction (e.g., the X-axis direction of FIG. 7H).

According to an embodiment, the stopper 431 may include a first stopper 431a disposed adjacent to one surface (e.g., the surface of the second body portion 473a shown in FIG. 7B or the surface facing in the +X direction of FIG. 7F) of the second gear portion 473 and a second stopper 431b disposed adjacent to the other surface (e.g., the surface of the second body portion 473a shown in FIG. 7C or the surface facing in the -X direction of FIG. 7F) facing in the direction opposite to the one surface of the second gear portion 473.

According to an embodiment, when the third gear portion 475 moves in the third sliding direction (e.g., the -X direction of FIG. 7H), the first stopper 431a may restrict movement of the second gear portion 473 in the third sliding direction.

According to an embodiment, when the third gear portion 475 moves in the fourth sliding direction (e.g., the +X direction of FIG. 7H), the second stopper 431b may restrict movement of the second gear portion 473 in the fourth sliding direction.

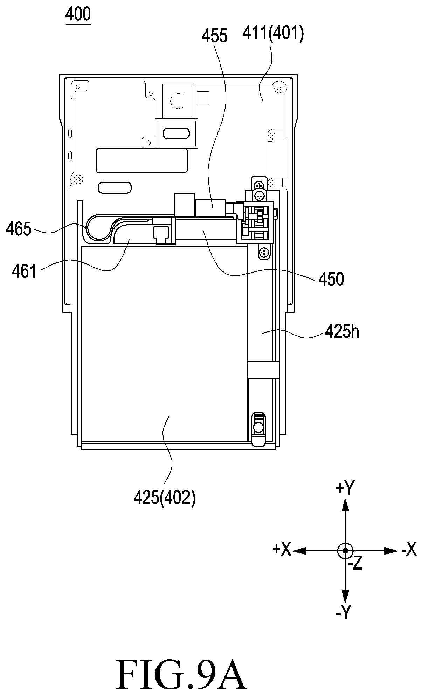

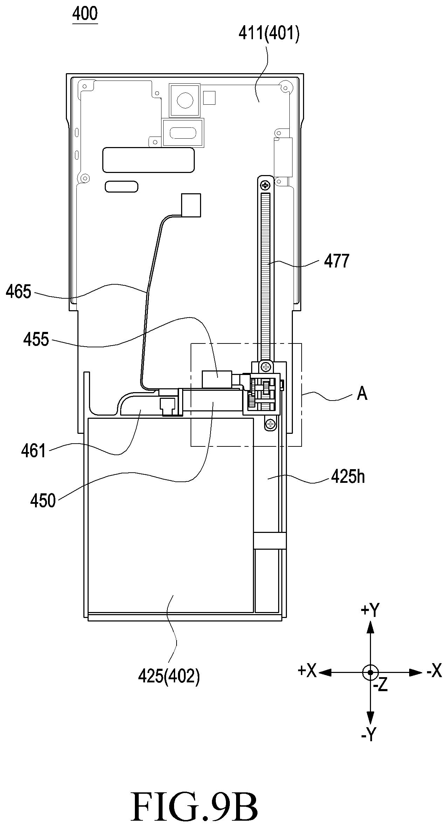

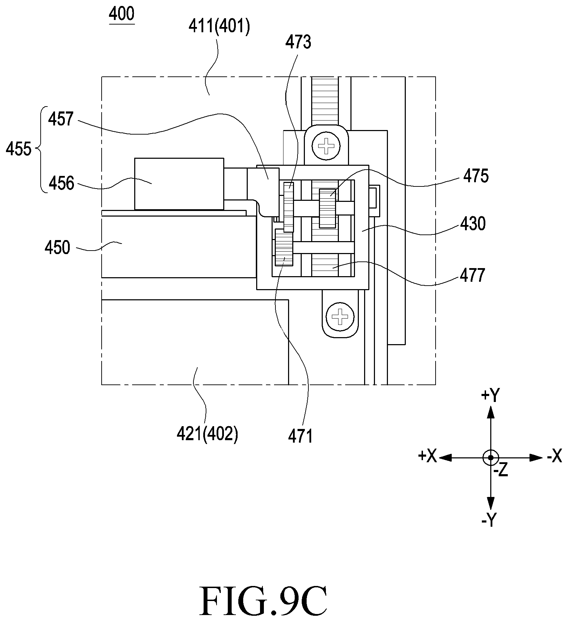

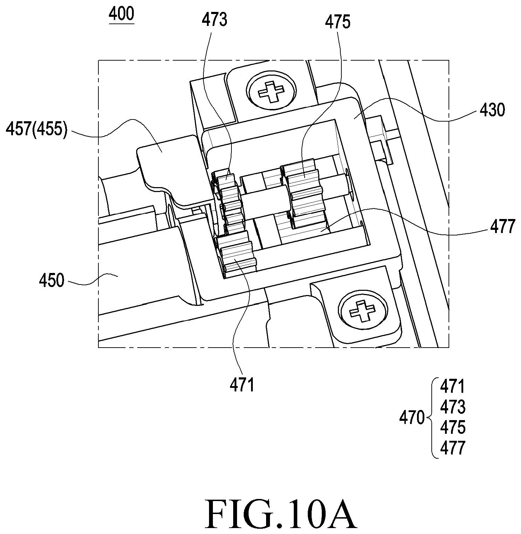

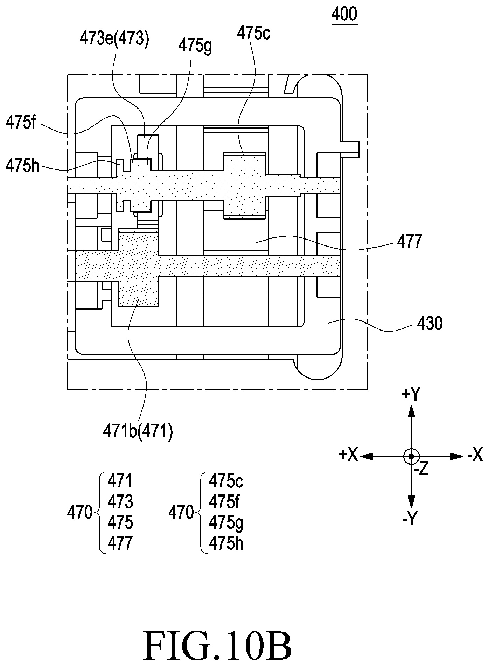

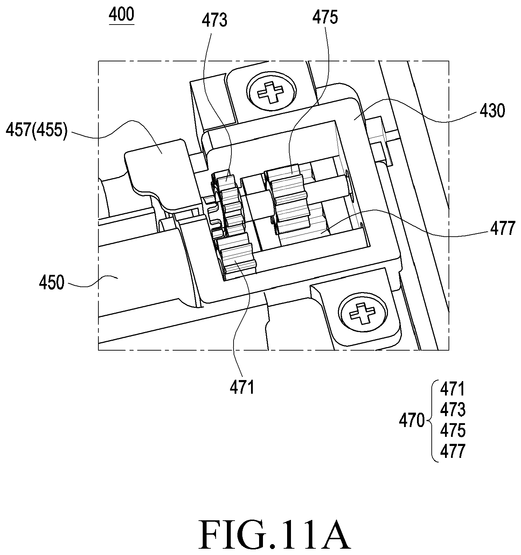

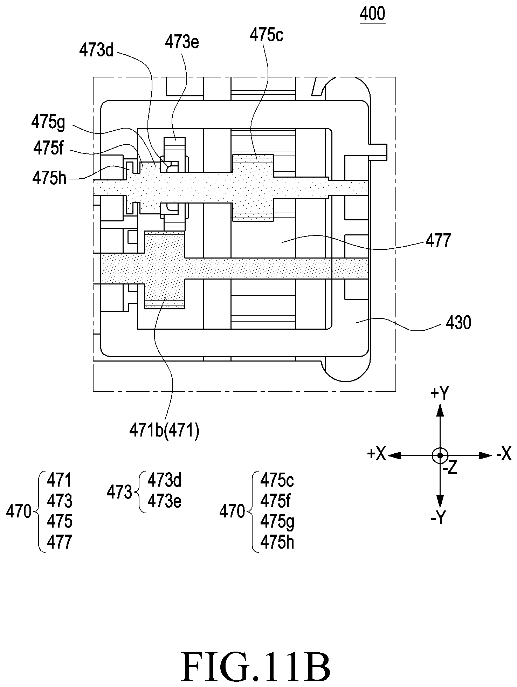

FIG. 9A is a view illustrating a closed state of an electronic device according to various embodiments of the disclosure. FIG. 9B is a view illustrating an opened state of an electronic device according to various embodiments of the disclosure. FIG. 9C is an enlarged view illustrating portion A of FIG. 9B according to various embodiments of the disclosure. FIG. 9A illustrates the electronic device 400 in the closed state (e.g., FIG. 2A), and FIG. 9B illustrates the electronic device 400 in the opened state (e.g., FIG. 2B). FIG. 10A is a perspective view illustrating a state in which a motor and a gear structure are dynamically connected to each other according to various embodiments of the disclosure. FIG. 10B is a cross-sectional view illustrating a state in which a motor and a gear structure are dynamically connected to each other according to various embodiments of the disclosure. FIG. 11A is a perspective view illustrating a state in which a motor and a gear structure are dynamically disconnected from each other according to various embodiments of the disclosure. FIG. 11B is a cross-sectional view illustrating a state in which a motor and a gear structure are dynamically disconnected from each other according to various embodiments of the disclosure.

Referring to FIGS. 9A to 11B, an electronic device 400 (e.g., the electronic device 400 of FIGS. 5 and 6) may include a first housing 401, a second housing 402, a guide frame 425, a motor 450, a driving member 455, a first printed circuit board 461, a flexible circuit board 465, a gear frame 430, a first gear portion 471, a second gear portion 473, a third gear portion 475, and a rack gear 477.

The configuration of the first housing 401, the second housing 402, the guide frame 425, the motor 450, the driving member 455, the first printed circuit board 461, the flexible circuit board 465, the gear frame 430, the first gear portion 471, the second gear portion 473, the third gear portion 475, and the rack gear 477 of FIGS. 9A to 11B may be identical in whole or part to the configuration of the first housing 401, the second housing 402, the guide frame 425, the motor 450, the driving member 455, the first printed circuit board 461, the flexible circuit board 465, the gear frame 430, the first gear portion 471, the second gear portion 473, the third gear portion 475, and the rack gear 477 of FIGS. 5 to 8B.

According to various embodiments, the guide frame 425 may further include a cover portion 425h. According to an embodiment, the cover portion 425h may be a component to cover at least a portion of the rack gear 477 in the closed state (e.g., FIG. 2B or FIG. 9B) of the electronic device 400. In an embodiment, the cover portion 425h of the guide frame 425 may be a portion formed to be recessed from one surface (e.g., the surface facing in the -Z direction of FIG. 6) of the guide frame 425 to the other surface (e.g., the surface facing in the +Z direction of FIG. 6) and extending along the length direction of the rack gear 477.

The operation or arrangement of the components when the electronic device 400 changes from the closed state to opened state is described with reference to FIGS. 7A to 10B.

According to an embodiment, the motor 450 may rotate in one direction, and the first gear portion 471 connected to the motor 450 may be rotated in the one direction.

According to an embodiment, the 1-1th gear 471c of the first gear portion 471 may be connected to the 2-1th gear 473e of the second gear portion 473, and the second gear portion 473 may be rotated in the other direction opposite to the one direction.

According to an embodiment, the 2-2th gear 473c of the second gear portion 473 may be connected to the 3-1th gear 475g of the third gear portion 475. According to an embodiment, as the switch portion 457 pressurizes at least a portion of the first circular plate 475f of the third gear portion 475 in the third sliding direction (e.g., the -X direction of FIGS. 9A to 9C), the 3-1th gear 475g may be inserted into the second insertion portion 473d of the second gear portion 473 and be connected with the 2-2th gear 473c. According to an embodiment, the third gear portion 475, along with the second gear portion 473, may be rotated in the other direction.

According to an embodiment, in the third gear portion 475, the 3-2th gear 475c may be connected to the rack gear 477. According to an embodiment, as the 3-2th gear 475c is rotated on the rack gear 477, the rack gear 477 may be slid in the first sliding direction (e.g., the +Y direction of FIGS. 9A to 9C). In an embodiment, since the rack gear 477 is fixed to the first plate 411, the first plate 411, along with the rack gear 477, may slide in the first sliding direction. In an embodiment, as the first plate 411 slides in the first sliding direction, which is a direction away from the guide frame 425, the electronic device 400 may be changed from the closed state (e.g., FIG. 2A or 9A) to the opened state (e.g., FIG. 2B or 9B).

According to an embodiment, the driving force of the motor 450 may be transferred to the first plate 411 through the first gear portion 471, the second gear portion 473, the third gear portion 475 and the rack gear 477.

The operation or arrangement of the components when the electronic device 400 changes from the opened state to closed state is described with reference to FIGS. 7A to 10B.

According to an embodiment, the motor 450 may rotate in the other direction, and the first gear portion 471 connected to the motor 450 may be rotated in the other direction.

According to an embodiment, the 1-1th gear 471c of the first gear portion 471 may be connected to the 2-1th gear 473e of the second gear portion 473, and the second gear portion 473 may be rotated in the one direction opposite to the other direction.

According to an embodiment, the 2-2th gear 473c of the second gear portion 473 may be connected to the 3-1th gear 475g of the third gear portion 475. According to an embodiment, as the switch portion 457 pressurizes at least a portion of the second circular plate 475h of the third gear portion 475 in the third sliding direction (e.g., the -X direction of FIGS. 9A to 9C), the 3-1th gear 475g may be inserted into the second insertion portion 473d of the second gear portion 473 and be connected with the 2-2th gear 473c. According to an embodiment, the third gear portion 475, along with the second gear portion 473, may be rotated in the one direction.

According to an embodiment, in the third gear portion 475, the 3-2th gear 475c may be connected to the rack gear 477. According to an embodiment, as the 3-2th gear 475c is rotated on the rack gear 477, the rack gear 477 may be slid in the second sliding direction (e.g., the -Y direction of FIGS. 9A to 9C). In an embodiment, since the rack gear 477 is fixed to the first plate 411, the first plate 411, along with the rack gear 477, may slide in the second sliding direction. In an embodiment, as the first plate 411 slides in the second sliding direction, which is a direction closer to the guide frame 425, the electronic device 400 may be changed from the opened state (e.g., FIG. 2B or 9B) to the closed state (e.g., FIG. 2A or 9A).

According to an embodiment, the driving force of the motor 450 may be transferred to the first plate 411 through the first gear portion 471, the second gear portion 473, the third gear portion 475 and the rack gear 477.

If the electronic device 400 is dropped while the electronic device 400 is in the opened state (e.g., FIG. 2B or FIG. 9B), the electronic device 400 collides with the ground or the floor, so that an external impact from the ground is applied to the electronic device 400. For example, if the electronic device 400 collides with the ground while the electronic device 400 is in the opened state, an external impact may be applied to the first housing 401 or the second housing 402 of the electronic device 400. Due to the external impact, the electronic device 400 may be unintentionally changed from the opened state to the closed state. In this case, if the first housing 401 or the second housing 402 is rapidly slid with respect to each other, the rack gear 477 may also be slid. The motor 450 may have a back-drive force in a stopped state, so that the first gear portion 471 may remain in a state not to be rotated. Accordingly, the second gear portion 473 connected to the first gear portion 471 and the third gear portion 475 connected to the second gear portion 473 may also remain in a state not to be rotated. In this case, if the rack gear 477 is momentarily slid, an external impact may be applied to the third gear portion 475, which is not to be rotated, through the rack gear 477, so that the rack gear 477 or the 3-2th gear 475c of the third gear portion 475 may be broken or the 3-1th shaft portion 475a or the 3-2th shaft portion 475d of the third gear portion 475 may be warped.

According to various embodiments, the electronic device 400 may disconnect the second gear portion 473 and the third gear portion 475 from each other, thereby restricting the occurrence of breakage or damage to the components when external impact is applied to the electronic device 400.

Hereinafter, a state in which the second gear portion 473 is disconnected from the third gear portion 475 is described with reference to FIGS. 7A to 7H and FIGS. 11A and 11B.

According to various embodiments, as the switch portion 457 slides in the fourth sliding direction (e.g., the +X direction of FIG. 11B), the driving member 455 may pressurize at least a portion of the second circular plate 473h of the third gear portion 475 in the fourth sliding direction (e.g., the +X direction of FIG. 11B). According to an embodiment, the third gear portion 475 may be slid in the fourth sliding direction (e.g., the +X direction of FIG. 11B), so that the 3-1th gear 475g of the third gear portion 475 and the 2-2th gear 473c of the second gear portion 473 may be disconnected from each other.

According to an embodiment, in a state in which the second gear portion 473 and the third gear portion 475 are disconnected from each other, the motor 450 may not be dynamically connected with the rack gear 477.

According to an embodiment, when external impact is applied to the electronic device 400, the rack gear 477 may be slid, and the third gear portion 475 connected with the rack gear 477 may be rotated by the rack gear 477.

According to an embodiment, when the third gear portion 475 is disconnected from the second gear portion 473, the back drive force of the motor 450 does not work, and the third gear portion 475 may be naturally rotated by the rack gear 477. In an embodiment, when the rack gear 477 is slid, the third gear portion 475 is naturally rotated. Thus, it is possible to prevent the rack gear 477 or the 3-2th gear 475c of the third gear portion 475 from being broken or the 3-1th shaft portion 475a or 3-2th shaft portion 475d of the third gear portion 475 from warping.

According to an embodiment, the rack gear 477 may have a width (e.g., the width in the X-axis direction of FIG. 11B) based on the sliding distance of the 3-2th gear 475c. For example, when the third gear portion 475 slides in the third sliding direction (e.g., the -X direction of FIG. 11B) or the fourth sliding direction (e.g., the +X direction of FIG. 11B), the rack gear 477 may have a width at which at least a portion of the 3-2th gear 475c remains connected to the rack gear 477.

According to an embodiment, when the third gear portion 475 is rotated, the third gear portion 475 is disconnected from the second gear portion 473. Thus, the 3-1th shaft portion 475a of the third gear portion 475 is freely rotated on the through portion 473b of the second gear portion 473, so that the second gear portion 473 may not be rotated together.

According to various embodiments, the electronic device 400 may further include a sensor module (e.g., the sensor module 176 of FIG. 1) and a processor (e.g., the processor 120 of FIG. 1).

According to an embodiment, the sensor module may include a pressure sensor or a gyro sensor.

According to various embodiments, the processor of the electronic device 400 may be configured to identify whether the electronic device 400 is dropped or is in a state of normal use through the information provided through the sensor module.

According to an embodiment, when the electronic device 400 is identified as dropped, the processor of the electronic device 400 may stop the operation of the motor 450 while cutting off the power to the solenoid 456. According to an embodiment, when the operation of the motor 450 is stopped, the motor 450 may form a back drive force. In an embodiment, when the power to the solenoid 456 is cut off, the switch portion 457 may be slid in the fourth sliding direction (e.g., the +X direction of FIG. 11B) by the return spring, pressurizing the second circular plate 475h in the fourth sliding direction.

According to an embodiment, as the third gear portion 475, along with the second circular plate 475h, is slid in the fourth sliding direction, the 3-1th gear 475g may be spaced apart from the 2-2th gear 473c. For example, the 3-1th gear 475g and the 2-2th gear 473c may be disconnected from each other.

According to an embodiment, if the electronic device 400 hits the ground or floor in a state in which the third gear portion 475 and the second gear portion 473 are disconnected from each other, the rack gear 477 or the third gear portion 475 may be prevented from being damaged.

According to an embodiment, upon identifying that the drop of the electronic device 400 ends or that the electronic device 400 is in the state of normal use, the processor of the electronic device 400 may supply power to the solenoid 456, allowing the switch portion 457 and the third gear portion 475 to slide in the third sliding direction (e.g., the -X direction of FIG. 11B). According to an embodiment, the processor of the electronic device 400 may control the rotation of the motor 450 in one direction or the other direction, thereby controlling the operation of the electronic device 400 so that the electronic device 400 is changed into the opened state or the closed state.

According to another embodiment (not shown), the motor 450 may be disposed adjacent to one side (e.g., the portion facing in the +X direction of FIG. 9C) of the gear frame 430, and the driving member 455 may be disposed adjacent to the other side (e.g., the portion facing in the -X direction of FIG. 9C) facing in the direction opposite to the one side of the gear frame 430. For example, the motor 450 and the driving member 455 may be disposed in opposite directions, with the gear frame 430 disposed therebetween. According to another embodiment, the switch portion 457 of the driving member 455 may be connected to at least a portion of the third gear portion 475. According to another embodiment, the first circular plate 475f and the second circular plate 475h may be disposed on the 3-2th shaft portion 475d, and the switch portion 457 of the driving member 455 may be inserted between the first circular plate 475f and the second circular plate 475h. According to another embodiment, the 3-1th gear 475g of the third gear portion 475 may be formed on a separate circular plate (not shown) which is disposed on the 3-1th shaft portion 475a and be connected to or disconnected from the 2-2th gear 473c of the second gear portion 473. According to another embodiment, upon identifying that the drop of the electronic device 400 is ended or that the electronic device 400 is in the state of normal use, the processor of the electronic device 400 may cut off the power to the solenoid 456. According to another embodiment, when the power to the solenoid 456 is cut off, the switch portion 457 may be slid by the return spring of the solenoid 456 in the third sliding direction (e.g., the -X direction of FIG. 9C), and the 3-1th gear 475g of the third gear portion 475 may be connected to the 2-2th gear 473c of the second gear portion 473. According to another embodiment, upon identifying that the electronic device 400 is dropped, the processor of the electronic device 400 may supply power to the solenoid 456. According to another embodiment, when power is supplied to the solenoid 456, the switch portion 457 may be slid by the plunger of the solenoid 456 in the fourth sliding direction (e.g., the +X direction of FIG. 9C), and the 3-1th gear 475g of the third gear portion 475 and the 2-2th gear 473c of the second gear portion 473 may be disconnected from each other. According to another embodiment (not shown), the motor 450 and driving member 455 of the electronic device 400 may be disposed adjacent to the other side (e.g., the portion facing in the -X direction of FIG. 9C) of the gear frame 430. According to an embodiment, when the electronic device 400 is detected as being in a first mode (or normal mode) (e.g., a mode, not an impact detection mode, or a normal use mode) through the processor and the sensor module, the electronic device 400 may control the solenoid 456 to connect the 3-1th gear 475g of the third gear portion 475 and the 2-2th gear 473c. In an embodiment, the first mode may be defined and interpreted as when the electronic device 400 is detected as being in a state different from the second mode. For example, the first mode may be the case where the electronic device 400 is detected as being in a state different from the second mode (e.g., the state in which the electronic device 400 is dropped), and the other state may be a normal use state of the electronic device 400 or a state in which the drop of the electronic device 400 is ended.

According to an embodiment, when the electronic device 400 is detected as being in the second mode (or impact detection mode) (e.g., when the electronic device 400 is detected as being dropped or falling) through the processor and the sensor module, the electronic device 400 may control the solenoid 456 to disconnect the 3-1th gear 475g of the third gear portion 475 and the 2-2th gear 473c. For example, the second mode may be defined and interpreted as a mode different from the first mode.

According to various embodiments of the disclosure, an electronic device (e.g., the electronic device 101 of FIG. 1 or the electronic device 400 of FIGS. 5 and 6) may comprise a second housing (e.g., the second housing 402 of guide frame 425 of FIGS. 5 and 6), a first housing (e.g., the first housing 401 or first plate 411 of FIGS. 5 and 6) configured to slide with respect to the second housing, a display (e.g., the display 403 of FIGS. 5 and 6) including a first display area (e.g., the first display area A1 of FIGS. 5 and 6) and a second display area (e.g., the second display area A2 of FIGS. 5 and 6) extending from the first display area and configured so that at least a portion of the second display area is moved based on a sliding movement of the first housing, a motor (e.g., the motor 450 of FIGS. 5 and 6) disposed in the second housing and configured to provide a driving force for the sliding movement of the first housing, and a gear structure (e.g., the gear structure 470 of FIGS. 5 and 6) configured to transfer the driving force provided from the motor to the first housing. The gear structure may include a first gear portion (e.g., the first gear portion 471 of FIGS. 5 to 7H) connected with the motor, a second gear portion (e.g., the second gear portion 473 of FIGS. 5 to 7H) connected with the first gear portion, a third gear portion (e.g., the third gear portion 475 of FIGS. 5 to 7H) connected with or disconnected from the second gear portion, and a rack gear (e.g., the rack gear 475 of FIGS. 5 and 6) disposed at the first housing and connected with the third gear portion.

According to various embodiments, the second gear portion may be configured to receive power of the motor through the first gear portion.

According to various embodiments, the display (e.g., the display 403 of FIGS. 5 and 6) may be a rollable display.

According to various embodiments, the electronic device may further comprise a driving member disposed in the second housing and configured to provide a driving force for a sliding movement of at least a portion of the gear structure.

According to various embodiments, the driving member may include a solenoid (e.g., the solenoid 456 of FIGS. 7G and 7H) and a switch portion (e.g., the switch portion 457 of FIGS. 7G and 7G) configured to reciprocate from the solenoid to the second gear portion.

According to various embodiments, the switch portion may include at least a portion connected to at least a portion (e.g., the third insertion portion 475i of FIGS. 7A to 7H) of the third gear portion. The third gear portion may be configured to reciprocate with the switch portion when the switch portion reciprocates from the solenoid.

According to various embodiments, the third gear portion may include at least a portion connected to at least a portion of the driving member and is slid based on the driving force provided from the driving member to be connected with or disconnected from the second gear portion.

According to various embodiments, the second gear portion may include a 2-1th gear (e.g., the 2-1th gear 473e of FIGS. 7A to 7H) and a 2-2th gear (e.g., the 2-2th gear 473c of FIGS. 7A to 7H). The 2-1th gear may be connected with the first gear portion. The third gear portion may include a 3-1th gear (e.g., the 3-1th gear 475g of FIGS. 7A to 7H) and a 3-2th gear (e.g., the 3-2th gear 475c of FIGS. 7A to 7H), and the 3-1th gear may be connected with or disconnected from the 2-2th gear, and the 3-2th gear may be connected with the rack gear.

According to various embodiments, the 2-1th gear may be disposed outside the second gear portion, and the 2-2th gear may be disposed inside the second gear portion.

According to various embodiments, the 3-1th gear may be engaged and connected with the 2-2th gear or spaced apart and disconnected from the 2-2th gear.

According to various embodiments, the 3-2th gear may be spaced apart from the 3-1th gear and connected with the rack gear.

According to various embodiments, the motor and the first gear portion may be configured to be dynamically connected with the rack gear when the 3-1th gear is connected with the 2-2th gear, and be not dynamically connected with the rack gear when the 3-1th gear is disconnected from the 2-2th gear.

According to various embodiments, the third gear portion may further include a shaft (e.g., the shaft 475a, 475d, 475e, and 475h of the third gear portion 475 of FIGS. 7A to 7H) coupled with the 3-1th gear and the 3-2th gear. The second gear portion may be disposed to be slidable on the shaft, and is positioned between the 3-1th gear and the 3-2th gear.

According to various embodiments, the electronic device may further comprise a gear frame (e.g., the gear frame 430 of FIGS. 5 and 6) configured to receive at least a portion of the first gear portion, the second gear portion, and the third gear portion.

According to various embodiments, the gear frame may be configured to rotatably support at least one of a shaft (e.g., the shaft 471a, 471e, and 471f of the first gear portion 471 of FIGS. 7A to 7H) of the second gear portion and a shaft (e.g., the shaft 475a, 475d, 475e, and 475j of the third gear portion 475 of FIGS. 7A to 7H) of the third gear portion.

According to various embodiments, the electronic device may further comprise a first bearing (e.g., the first bearing 472 of FIGS. 5 and 6) disposed at the gear frame and configured to rotatably support the first gear portion and a second bearing (e.g., the second bearing 476 of FIGS. 5 and 6) disposed at the gear frame and configured to rotatably support the third gear portion.

According to various embodiments, the gear frame may include a stopper (e.g., the stopper 431 of FIGS. 8A and 8B) configured to restrict a sliding movement of the second gear portion.

According to various embodiments, the stopper may include a first stopper (e.g., the first stopper 431a of FIGS. 8A and 8B) disposed adjacent to one surface of the second gear portion and a second stopper (e.g., the second stopper 431b of FIGS. 8A and 8B) disposed adjacent to another surface facing in a direction opposite to the one surface of the second gear portion.

According to various embodiments, the third gear portion may include a shaft (e.g., the shaft 475a, 475d, 475e, and 475j of the third gear portion 475 of FIGS. 7A to 7H), a first circular plate (e.g., the first circular plate 475f of the third gear portion 475 of FIGS. 7A to 7H) disposed on the shaft, a second circular plate (e.g., the second circular plate 475h of FIGS. 7A to 7H) disposed on the shaft and spaced apart from the first circular plate, a 3-1th gear connected with the first circular plate, and a 3-2th gear spaced apart from the 3-2th gear. At least a portion (e.g., the switch portion 457 of FIGS. 7G and 7H) of the driving member may be disposed between the first circular plate and the second circular plate.

According to various embodiments, the 3-1th gear may include a first inclined surface (e.g., the first inclined surface 475g-1 of FIG. 7F) extending from the first circular plate to the second gear portion and formed to be inclined at at least a portion of the 3-1th gear. The 2-2th gear may include a second inclined surface (e.g., the second inclined surface 473c-1 of FIG. 7F) formed to be inclined at at least a portion of the 2-2th gear.

According to various embodiments of the disclosure, an electronic device (e.g., the electronic device 101 of FIG. 1 or the electronic device 400 of FIGS. 5 and 6) may comprise a second housing (e.g., the second housing 402 or guide frame 425 of FIGS. 5 and 6), a first housing (e.g., the first housing 401 or first plate 411 of FIGS. 5 and 6) configured to slide with respect to the second housing, a display (e.g., the display 403 of FIGS. 5 and 6) including a first display area (e.g., the first display area A1 of FIGS. 5 and 6) and a second display area (e.g., the second display area A2 of FIGS. 5 and 6) extending from the first display area and configured so that at least a portion of the second display area is moved based on a sliding movement of the first housing, a motor (e.g., the motor 450 of FIGS. 5 and 6) disposed in the second housing and configured to provide a driving force for the sliding movement of the first housing, a gear structure (e.g., the gear structure 470 of FIGS. 5 and 6) configured to transfer the driving force provided from the motor to the first housing, and a driving member (e.g., the driving member 455 of FIGS. 5 and 6) disposed in the second housing and configured to provide a driving force for sliding at least a portion of the gear structure. The gear structure may include a first gear portion (e.g., the first gear portion 471 of FIGS. 5 to 7H) connected with the motor, a second gear portion (e.g., the second gear portion 473 of FIGS. 5 to 7h) including a 2-1th gear (e.g., the 2-1th gear 473e of FIGS. 7A to 7H) and a 2-2th gear (e.g., the 2-2th gear 473c of FIGS. 7A to 7H), the 2-1th gear connected with the first gear portion, a third gear portion (e.g., the third gear portion 475 of FIGS. 5 to 7H) including a 3-1th gear (e.g., the 3-1th gear 475g of FIGS. 7A to 7H) and a 3-2th gear (e.g., the 3-2th gear 475c of FIGS. 7A to 7H), the 3-1th gear configured to be connected with or disconnected from the 2-2th gear, and a rack gear (e.g., the rack gear 477 of FIGS. 5 and 6) disposed at the first housing and connected with the 3-2th gear. The third gear portion may be configured to connect the 3-1th gear with the 2-2th gear in a first mode and disconnect the 3-1th gear from the 2-2th gear in a second mode.

According to various embodiments, the second mode may be when the electronic device is detected as being in a falling state, and the first mode may be when the electronic device is detected as being in a state different from the second mode.

According to various embodiments, the first gear portion, the second gear portion and/or the third gear portion may include at least one cogwheel of toothed wheel.

According to various embodiments, the first bearing and/or the second bearing may be sliding contact bearings or rolling bearings.

## Claims

1. An electronic device (101, 200, 300, 400) comprising:
a second housing (202, 302, 402);
a first housing (201, 301, 401) configured to slide with respect to the second housing (202, 302, 402);
a display (203, 303, 403) including a first display area (A1) and a second display area (A2) extending from the first display area (A1) and configured so that at least a portion of the second display area (A2) is configured to be moved based on a sliding movement of the first housing (201, 301, 401);
a motor (351, 450) disposed in the second housing (202, 302, 402) and configured to provide a driving force for the sliding movement of the first housing (201, 301, 401); and
a gear structure (470) configured to transfer the driving force provided from the motor (351, 450) to the first housing (201, 301, 401); and
a solenoid (456) disposed in the second housing (202, 302, 402) and configured to provide a driving force for a sliding movement of at least a portion of the gear structure (470),
wherein the gear structure (470) includes:
a first gear portion (471) connected with the motor (351, 450);
a second gear portion (473) connected with the first gear portion (471);
a third gear portion (475) configured to be connected with or disconnected from the second gear portion (473), the third gear portion (475) configured to slide based on the driving force provided from the solenoid (456); and
a rack gear (477) disposed at the first housing (201, 301, 401) and connected with the third gear portion (475).

2. The electronic device (101, 200, 300, 400) of claim 1, further comprising a driving member (455) comprising the solenoid (456) and a switch portion (457) configured to reciprocate between the solenoid (456) and the second gear portion (473).

3. The electronic device (101, 200, 300, 400) of claim 2, wherein the switch portion (457) includes at least a portion connected to at least a portion of the third gear portion (475), and
wherein the third gear portion (475) is configured to reciprocate with the switch portion (457) when the switch portion (457) reciprocates from the solenoid (456).

4. The electronic device (101, 200, 300, 400) of claim 2, wherein the third gear portion (475) includes at least a portion connected to the switch portion (457) of the driving member (455).

5. The electronic device (101, 200, 300, 400) of any one of the preceding claims, wherein the second gear portion (473) includes a 2-1th gear (473e) and a 2-2th gear (473c), wherein the 2-1th gear (473e) is connected with the first gear portion (471), and
wherein the third gear portion (475) includes a 3-1th gear (475g) and a 3-2th gear (475c), and the 3-1th gear (475g) is connected with or disconnected from the 2-2th gear (473c), and the 3-2th gear (475c) is connected with the rack gear (477).

6. The electronic device (101, 200, 300, 400) of claim 5, wherein the 2-1th gear (473e) is disposed outside the second gear portion (473),
wherein the 2-2th gear (473c) is disposed inside the second gear portion (473),
wherein the 3-1th gear (475g) is engaged and connected with the 2-2th gear (473c) or spaced apart and disconnected from the 2-2th gear (473c), and
wherein the 3-2th gear (475c) is spaced apart from the 3-1th gear (475g) and connected with the rack gear (477).

7. The electronic device (101, 200, 300, 400) of claim 5, wherein the motor (351, 450) and the first gear portion (471) are configured to,
be dynamically connected with the rack gear (477) when the 3-1th gear (475g) is connected with the 2-2th gear (473c), and
be not dynamically connected with the rack gear (477) when the 3-1th gear (475g) is disconnected from the 2-2th gear (473c).

8. The electronic device (101, 200, 300, 400) of claim 5, wherein the third gear portion (475) further includes a shaft (475a, 475d, 475e, 475j) coupled with the 3-1th gear (475g) and the 3-2th gear (475c), and
wherein the second gear portion (473) is disposed to be slidable on the shaft (475a, 475d, 475e, 475j), and is positioned between the 3-1th gear (475g) and the 3-2th gear (475c).

9. The electronic device (101, 200, 300, 400) of any one of the claims 1 to 7, further comprising a gear frame (430) configured to receive at least a portion of the first gear portion (471), the second gear portion (473), and the third gear portion (475).

10. The electronic device (101, 200, 300, 400) of claim 9, wherein the gear frame (430) is configured to rotatably support at least one of a shaft (471a, 471e, 471f) of the first gear portion (473) and a shaft (475a, 475d, 475e, 475j) of the third gear portion (475).

11. The electronic device (101, 200, 300, 400) of claim 9, wherein the gear frame (430) includes a stopper (431) configured to restrict a sliding movement of the second gear portion (473).

12. The electronic device (101, 200, 300, 400) of claim 5, wherein the third gear portion (475) includes a shaft (475a, 475d, 475e, 475j), a first circular plate (475f) disposed on the shaft (475a, 475d, 475e, 475j), a second circular plate (475h) disposed on the shaft (475a, 475d, 475e, 475j) and spaced apart from the first circular plate (475f), a 3-1th gear (475g) connected with the first circular plate (475f), and a 3-1th gear (475g) spaced apart from the 3-2th gear (475c), and
wherein at least a portion of the driving member (455) is disposed between the first circular plate (475f) and the second circular plate (475h).

13. The electronic device (101, 200, 300, 400) of claim 5, wherein the third gear portion (475) is configured to,
connect the 3-1th gear (475g) with the 2-2th gear (473c) in a first mode, and
disconnect the 3-1th gear (475g) from the 2-2th gear (473c) in a second mode.

14. The electronic device (101, 200, 300, 400) of claim 13, wherein the second mode is when the electronic device (101, 200, 300, 400) is detected as being in a falling state, and
wherein the first mode is when the electronic device (101, 200, 300, 400) is detected as being in a state different from the second mode.

## Patentansprüche

1. Elektronische Vorrichtung (101, 200, 300, 400), umfassend:
ein zweites Gehäuse (202, 302, 402);
ein erstes Gehäuse (201, 301, 401), das dazu konfiguriert ist, in Bezug auf das zweite Gehäuse (202, 302, 402) zu gleiten;
eine Anzeige (203, 303, 403), die einen ersten Anzeigebereich (A1) und einen zweiten Anzeigebereich (A2), der sich vom ersten Anzeigebereich (A1) erstreckt, umfasst und so konfiguriert ist, dass zumindest ein Abschnitt des zweiten Anzeigebereichs (A2) dazu konfiguriert ist, auf der Grundlage einer Gleitbewegung des ersten Gehäuses (201, 301, 401) bewegt zu werden;
einen Motor (351, 450), der im zweiten Gehäuse (202, 302, 402) angeordnet und dazu konfiguriert ist, eine Antriebskraft für die Gleitbewegung des ersten Gehäuses (201, 301, 401) bereitzustellen; und
eine Getriebestruktur (470), die dazu konfiguriert ist, die vom Motor (351, 450) bereitgestellte Antriebskraft auf das erste Gehäuse (201, 301, 401) zu übertragen; und
ein Solenoid (456), das in dem zweiten Gehäuse (202, 302, 402) angeordnet und dazu konfiguriert ist, eine Antriebskraft für eine Gleitbewegung zumindest eines Abschnitts der Getriebestruktur (470) bereitzustellen,
wobei die Getriebestruktur (470) Folgendes umfasst:
einen ersten Getriebeabschnitt (471), der mit dem Motor (351, 450) verbunden ist;
einen zweiten Getriebeabschnitt (473), der mit dem ersten Getriebeabschnitt (471) verbunden ist;
einen dritten Getriebeabschnitt (475), der dazu konfiguriert ist, mit dem zweiten Getriebeabschnitt (473) verbunden oder von diesem getrennt zu werden, wobei der dritte Getriebeabschnitt (475) dazu konfiguriert ist, auf der Grundlage der vom Solenoid (456) bereitgestellten Antriebskraft zu gleiten; und
eine Zahnstange (477), die am ersten Gehäuse (201, 301, 401) angeordnet und mit dem dritten Getriebeabschnitt (475) verbunden ist.

2. Elektronische Vorrichtung (101, 200, 300, 400) nach Anspruch 1, umfassend ferner ein Antriebselement (455), das das Solenoid (456) und einen Schalterabschnitt (457) umfasst, der dazu konfiguriert ist, sich zwischen dem Solenoid (456) und dem zweiten Getriebeabschnitt (473) hin- und her zu bewegen.

3. Elektronische Vorrichtung (101, 200, 300, 400) nach Anspruch 2, wobei der Schalterabschnitt (457) mindestens einen Abschnitt umfasst, der mit mindestens einem Abschnitt des dritten Getriebeabschnitts (475) verbunden ist, und
wobei der dritte Getriebeabschnitt (475) dazu konfiguriert ist, sich mit dem Schalterabschnitt (457) hin- und her zu bewegen, wenn sich der Schalterabschnitt (457) vom Solenoid (456) hin- und herbewegt.

4. Elektronische Vorrichtung (101, 200, 300, 400) nach Anspruch 2, wobei der dritte Getriebeabschnitt (475) mindestens einen Abschnitt umfasst, der mit dem Schalterabschnitt (457) des Antriebselements (455) verbunden ist.

5. Elektronische Vorrichtung (101, 200, 300, 400) nach einem der vorstehenden Ansprüche, wobei der zweite Getriebeabschnitt (473) ein 2-1-tes Getriebe (473e) und ein 2-2-tes Getriebe (473c) umfasst, wobei das 2-1-te Getriebe (473e) mit dem ersten Getriebeabschnitt (471) verbunden ist, und
wobei der dritte Getriebeabschnitt (475) ein 3-1-tes Getriebe (475g) und ein 3-2-tes Getriebe (475c) umfasst, wobei das 3-1-te Getriebe (475g) mit dem 2-2-ten Getriebe (473c) verbunden oder von diesem getrennt ist, während das 3-2-te Getriebe (475c) mit der Zahnstange (477) verbunden ist.

6. Elektronische Vorrichtung (101, 200, 300, 400) nach Anspruch 5, wobei das 2-1-te Getriebe (473e) außerhalb des zweiten Getriebeabschnitts (473) angeordnet ist,
wobei das 2-2-te Getriebe (473c) innerhalb des zweiten Getriebeabschnitts (473) angeordnet ist,
wobei das 3-1-te Getriebe (475g) mit dem 2-2-ten Getriebe (473c) in Eingriff steht und verbunden ist oder von dem 2-2-ten Getriebe (473c) beabstandet und getrennt ist, und
wobei das 3-2-te Getriebe (475c) von dem 3-1-ten Getriebe (475g) beabstandet und mit der Zahnstange (477) verbunden ist.

7. Elektronische Vorrichtung (101, 200, 300, 400) nach Anspruch 5, wobei der Motor (351, 450) und der erste Getriebeabschnitt (471) dazu konfiguriert sind,
dynamisch mit der Zahnstange (477) verbunden zu sein, wenn das 3-1-te Getriebe (475g) mit dem 2-2-ten Getriebe (473c) verbunden ist, und
nicht dynamisch mit der Zahnstange (477) verbunden zu sein, wenn das 3-1-te Getriebe (475g) vom 2-2-ten Getriebe (473c) getrennt ist.

8. Elektronische Vorrichtung (101, 200, 300, 400) nach Anspruch 5, wobei der dritte Getriebeabschnitt (475) ferner eine Welle (475a, 475d, 475e, 475j) umfasst, die mit dem 3-1-ten Getriebe (475g) und dem 3-2-ten Getriebe (475c) gekoppelt ist, und
wobei der zweite Getriebeabschnitt (473) so angeordnet ist, dass er auf der Welle (475a, 475d, 475e, 475j) gleiten kann, und zwischen dem 3-1-ten Getriebe (475g) und dem 3-2-ten Getriebe (475c) positioniert ist.

9. Elektronische Vorrichtung (101, 200, 300, 400) nach einem der Ansprüche 1 bis 7, umfassend ferner einen Getrieberahmen (430), der zur Aufnahme mindestens eines Abschnitts des ersten Getriebeabschnitts (471), des zweiten Getriebeabschnitts (473) und des dritten Getriebeabschnitts (475) konfiguriert ist.

10. Elektronische Vorrichtung (101, 200, 300, 400) nach Anspruch 9, wobei der Getrieberahmen (430) dazu konfiguriert ist, mindestens eine von einer Welle (471a, 471e, 471f) des ersten Getriebeabschnitts (473) und einer Welle (475a, 475d, 475e, 475j) des dritten Getriebeabschnitts (475) drehbar zu stützen.

11. Elektronische Vorrichtung (101, 200, 300, 400) nach Anspruch 9, wobei der Getrieberahmen (430) einen Anschlag (431) umfasst, der zur Begrenzung einer Gleitbewegung des zweiten Getriebeabschnitts (473) konfiguriert ist.

12. Elektronische Vorrichtung (101, 200, 300, 400) nach Anspruch 5, wobei der dritte Getriebeabschnitt (475) eine Welle (475a, 475d, 475e, 475j), eine erste kreisförmige Platte (475f), die auf der Welle (475a, 475d, 475e, 475j) angeordnet ist, eine zweite kreisförmige Platte (475h), die auf der Welle (475a, 475d, 475e, 475j) angeordnet und von der ersten kreisförmigen Platte (475f) beabstandet ist, ein 3-1-tes Getriebe (475g), das mit der ersten kreisförmigen Platte (475f) verbunden ist, und ein 3-1-tes Getriebe (475g), das von dem 3-2-ten Getriebe (475c) beabstandet ist, umfasst, und
wobei zumindest ein Abschnitt des Antriebselements (455) zwischen der ersten kreisförmigen Platte (475f) und der zweiten kreisförmigen Platte (475h) angeordnet ist.

13. Elektronische Vorrichtung (101, 200, 300, 400) nach Anspruch 5, wobei der dritte Getriebeabschnitt (475) dazu konfiguriert ist,
in einem ersten Modus das 3-1-te Getriebe (475g) mit dem 2-2-ten Getriebe (473c) zu verbinden und
in einem zweiten Modus das 3-1-te Getriebe (475g) vom 2-2-ten Getriebe (473c) zu trennen.

14. Elektronische Vorrichtung (101, 200, 300, 400) nach Anspruch 13, wobei der zweite Modus vorliegt, wenn die elektronische Vorrichtung (101, 200, 300, 400) als in einem Fallzustand befindlich erkannt wird, und
wobei der erste Modus vorliegt, wenn die elektronische Vorrichtung (101, 200, 300, 400) als in einem vom zweiten Modus verschiedenen Zustand befindlich erkannt wird.

## Revendications

1. Dispositif électronique (101, 200, 300, 400) comprenant :
un second boîtier (202, 302, 402) ;
un premier boîtier (201, 301, 401) configuré pour coulisser par rapport au second boîtier (202, 302, 402) ;
un affichage (203, 303, 403) comportant une première zone d'affichage (A1) et une seconde zone d'affichage (A2) s'étendant à partir de la première zone d'affichage (A1) et configuré de sorte qu'au moins une partie de la seconde zone d'affichage (A2) est configurée pour être déplacée sur la base d'un mouvement de coulissement du premier boîtier (201, 301, 401) ;
un moteur (351, 450) disposé dans le second boîtier (202, 302, 402) et configuré pour fournir une force d'entraînement pour le mouvement de coulissement du premier boîtier (201, 301, 401) ; et
une structure d'engrenages (470) configurée pour transférer la force d'entraînement fournie par le moteur (351, 450) au premier boîtier (201, 301, 401) ; et
un solénoïde (456) disposé dans le second boîtier (202, 302, 402) et configuré pour fournir une force d'entraînement pour un mouvement de coulissement d'au moins une partie de la structure d'engrenages (470),
dans lequel la structure d'engrenages (470) comprend :
une première partie d'engrenage (471) reliée au moteur (351, 450) ;
une deuxième partie d'engrenage (473) reliée à la première partie d'engrenage (471) ;
une troisième partie d'engrenage (475) configurée pour être reliée à la deuxième partie d'engrenage (473) ou déreliée de celle-ci, la troisième partie d'engrenage (475) étant configurée pour coulisser sur la base de la force d'entraînement fournie par le solénoïde (456); et
un engrenage à crémaillère (477) disposé au niveau du premier boîtier (201, 301, 401) et relié à la troisième partie d'engrenage (475).

2. Dispositif électronique (101, 200, 300, 400) selon la revendication 1, comprenant en outre un organe d'entraînement (455) comprenant le solénoïde (456) et une partie de commutation (457) configurée pour effectuer un mouvement alternatif entre le solénoïde (456) et la deuxième partie d'engrenage (473).

3. Dispositif électronique (101, 200, 300, 400) selon la revendication 2, dans lequel la partie de commutation (457) comporte au moins une partie reliée à au moins une partie de la troisième partie d'engrenage (475), et
dans lequel la troisième partie d'engrenage (475) est configurée pour effectuer un mouvement alternatif avec la partie de commutation (457) lorsque la partie de commutation (457) effectue un mouvement alternatif à partir du solénoïde (456).

4. Dispositif électronique (101, 200, 300, 400) selon la revendication 2, dans lequel la troisième partie d'engrenage (475) comprend au moins une partie reliée à la partie de commutation (457) de l'organe d'entraînement (455).

5. Dispositif électronique (101, 200, 300, 400) selon l'une quelconque des revendications précédentes, dans lequel la deuxième partie d'engrenage (473) comporte un 2-1ème engrenage (473e) et un 2-2ème engrenage (473c), dans lequel le 2-1ème engrenage (473e) est relié à la première partie d'engrenage (471), et
dans lequel la troisième partie d'engrenage (475) comporte un 3-1ème engrenage (475g) et un 3-2ème engrenage (475c), et le 3-1ème engrenage (475g) est relié au 2-2ème engrenage (473c) ou dérelié de celui-ci, et le 3-2ème engrenage (475c) est relié à l'engrenage à crémaillère (477).

6. Dispositif électronique (101, 200, 300, 400) selon la revendication 5, dans lequel le 2-1ème engrenage (473e) est disposé à l'extérieur de la deuxième partie d'engrenage (473),
dans lequel le 2-2ème engrenage (473c) est disposé à l'intérieur de la deuxième partie d'engrenage (473),
dans lequel le 3-1ème engrenage (475g) est engrené et relié au 2-2ème engrenage (473c) ou espacé de celui-ci et dérelié de celui-ci, et
dans lequel le 3-2ème engrenage (475c) est espacé du 3-1ème engrenage (475g) et relié à l'engrenage à crémaillère (477).

7. Dispositif électronique (101, 200, 300, 400) selon la revendication 5, dans lequel le moteur (351, 450) et la première partie d'engrenage (471) sont configurés pour,
être reliés dynamiquement à l'engrenage à crémaillère (477) lorsque le 3-1ème engrenage (475g) est relié au 2-2ème engrenage (473c), et
ne pas être reliés dynamiquement à l'engrenage à crémaillère (477) lorsque le 3-1ème engrenage (475g) est dérelié du 2-2ème engrenage (473c).

8. Dispositif électronique (101, 200, 300, 400) selon la revendication 5, dans lequel la troisième partie d'engrenage (475) comporte en outre un arbre (475a, 475d, 475e, 475j) couplé au 3-1ème engrenage (475g) et au 3-2ème engrenage (475c), et
dans lequel la deuxième partie d'engrenage (473) est disposée de manière à pouvoir coulisser sur l'arbre (475a, 475d, 475e, 475j), et est positionnée entre le 3-1ème engrenage (475g) et le 3-2ème engrenage (475c).

9. Dispositif électronique (101, 200, 300, 400) selon l'une quelconque des revendications 1 à 7, comprenant en outre un châssis d'engrenages (430) configuré pour recevoir au moins une partie de la première partie d'engrenage (471), de la deuxième partie d'engrenage (473), et de la troisième partie d'engrenage (475).

10. Dispositif électronique (101, 200, 300, 400) selon la revendication 9, dans lequel le châssis d'engrenages (430) est configuré pour supporter de manière rotative au moins l'un parmi un arbre (471a, 471e, 471f) de la première partie d'engrenage (473) et un arbre (475a, 475d, 475e, 475j) de la troisième partie d'engrenage (475).

11. Dispositif électronique (101, 200, 300, 400) selon la revendication 9, dans lequel le châssis d'engrenages (430) comporte une butée (431) configurée pour limiter un mouvement de coulissement de la deuxième partie d'engrenage (473).

12. Dispositif électronique (101, 200, 300, 400) selon la revendication 5, dans lequel la troisième partie d'engrenage (475) comporte un arbre (475a, 475d, 475e, 475j), une première plaque circulaire (475f) disposée sur l'arbre (475a, 475d, 475e, 475j), une deuxième plaque circulaire (475h) disposée sur l'arbre (475a, 475d, 475e, 475j) et espacée de la première plaque circulaire (475f), un 3-1ème engrenage (475g) relié à la première plaque circulaire (475f), et un 3-1ème engrenage (475g) espacé du 3-2ème engrenage (475c), et
dans lequel au moins une partie de l'organe d'entraînement (455) est disposée entre la première plaque circulaire (475f) et la deuxième plaque circulaire (475h).

13. Dispositif électronique (101, 200, 300, 400) selon la revendication 5, dans lequel la troisième partie d'engrenage (475) est configurée pour,
connecter le 3-1ème engrenage (475g) au 2-2ème engrenage (473c) dans un premier mode, et
déconnecter le 3-1ème engrenage (475g) du 2-2ème engrenage (473c) dans un second mode.

14. Dispositif électronique (101, 200, 300, 400) selon la revendication 13, dans lequel le second mode est lorsque le dispositif électronique (101, 200, 300, 400) est détecté comme étant dans un état de chute, et
dans lequel le premier mode est lorsque le dispositif électronique (101, 200, 300, 400) est détecté comme étant dans un état différent du second mode.
